(19) **Europäisches Patentamt / European Patent Office / Office européen des brevets**

(11) **EP 4 202 591 B1**

(12) **EUROPEAN PATENT SPECIFICATION**

(45) Date of publication and mention
of the grant of the patent:
**01.10.2025 Bulletin 2025/40**

(21) Application number: **22200798.1**

(22) Date of filing: **11.10.2022**

(51) International Patent Classification (IPC):
**G05D 1/229** (2024.01)    **G05D 1/698** (2024.01)
**G05D 101/15** (2024.01)    **G05D 105/45** (2024.01)
**G05D 107/70** (2024.01)    **G05D 109/10** (2024.01)
**G06N 20/00** (2019.01)    **G05B 19/418** (2006.01)

(52) Cooperative Patent Classification (CPC):
**G05B 19/4188; G05D 1/2297; G05D 1/6987;**
**G06N 20/00;** G05B 2219/32085; G05B 2219/32334;
G05D 2101/15; G05D 2105/45; G05D 2107/70;
G05D 2109/10; G06N 3/0464; G06N 3/0475

(54) **DEVICES AND NON-TRANSITORY COMPUTER-READABLE MEDIUM FOR A COLLABORATION OF AUTOMATED AND AUTONOMOUS MACHINES**

VORRICHTUNGEN UND NICHT-ÜBERTRAGBARES COMPUTER-LESBARES MEDIUM ZUR ZUSAMMENARBEIT AUTOMATISIERTER UND AUTONOMER MASCHINEN

DISPOSITIFS ET SUPPORT NON TRANSITOIRE LISIBLE PAR ORDINATEUR POUR UNE COLLABORATION DE MACHINES AUTOMATISÉES ET AUTONOMES

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**

(30) Priority: **23.12.2021 US 202117560300**

(43) Date of publication of application:
**28.06.2023 Bulletin 2023/26**

(73) Proprietor: **INTEL Corporation**
**Santa Clara, CA 95054 (US)**

(72) Inventors:
• **NATARAJAN, Venkataraman**
**570078 Bangalore, KA (IN)**
• **VAIDYA, Nishtha Namdeo**
**400708 Maharashtra (IN)**
• **SHUKLA, Santosh**
**560087 Bengaluru, KA (IN)**

(74) Representative: **Viering, Jentschura & Partner mbB**
**Patent- und Rechtsanwälte**
**Am Brauhaus 8**
**01099 Dresden (DE)**

(56) References cited:
WO-A1-2020/138485      CN-A- 112 015 174
US-A1- 2021 200 239      US-A1- 2022 055 214
US-A1- 2022 317 695

## Description

### Technical Field

This disclosure generally relates to devices and non-transitory computer-readable medium for a collaboration of automated and autonomous machines.

### Background

In accordance with various artificial intelligence-based industrial applications, automated and/or autonomous machines may operate within a cluster and collaboratively perform actions with automated and/or autonomous machines of the same cluster or with other automated and/or autonomous machines of other clusters in a deployment environment based on one or more input tasks. Each automated and/or autonomous machine may perform its assigned tasks according to the input tasks based on a task performance model that may include an operation policy designed to guide the respective automated and/or autonomous machine to perform a defined task. Examples are disclosed in WO 2020 / 138485 A1, US 2021 / 200239 A1, and CN 112 015 174 A.

### Brief Description of the Drawings

In the drawings, like reference characters generally refer to the same parts throughout the different views. The drawings are not necessarily to scale, emphasis instead generally being placed upon illustrating the principles of the disclosure. In the following description, various aspects of the disclosure are described with reference to the following drawings, in which:

FIG. 1 shows an example of an autonomous machine;
FIG. 2 shows various exemplary electronic components of a machine;
FIG. 3 shows an exemplary illustration of an environment;
FIG. 4 shows an example of a device;
FIG. 5 shows an example of a processor of a device;
FIG. 6 shows an illustration of an exemplary AI/ML module;
FIG. 7 shows an example of a flow diagram showing an on-the-fly policy learning;
FIG. 8 shows an example of an AI/ML;
FIG. 9 shows an example of an AI/ML;
FIG. 10 exemplarily shows an illustration with respect to three generated layouts;
FIG. 11 shows an example illustration with respect to a trained layout and a determined layout for an AMR cluster;
FIG. 12 shows an example of an AI/ML;
FIG. 13 shows an illustration including a plurality of AMRs;
FIG. 14 exemplarily shows a training flow diagram;
FIG. 15 shows an exemplary illustration for a re-plan decision;
FIG. 16 shows an exemplary flow diagram with respect to adaptive planning;
FIG. 17 shows an example of a system;
FIG. 18 shows an example of a method.

### Description

The invention is set out in the appended set of claims. The invention provides an improved operation of a plurality of automated machines.

The following detailed description refers to the accompanying drawings that show, by way of illustration, exemplary details and aspects in which aspects of the present disclosure may be practiced.

Any vector and/or matrix notation utilized herein is exemplary in nature and is employed solely for purposes of explanation. Accordingly, the apparatuses and methods of this disclosure accompanied by vector and/or matrix notation are not limited to being implemented solely using vectors and/or matrices, and that the associated processes and computations may be equivalently performed with respect to sets, sequences, groups, etc., of data, observations, information, signals, samples, symbols, elements, etc.

As used herein, "memory" is understood as a non-transitory computer-readable medium in which data or information can be stored for retrieval. References to "memory" included herein may thus be understood as referring to volatile or non-volatile memory, including random access memory ("RAM"), read-only memory ("ROM"), flash memory, solid-state storage, magnetic tape, hard disk drive, optical drive, etc., or any combination thereof. Furthermore, registers, shift registers, processor registers, data buffers, etc., are also embraced herein by the term memory. A single component referred to as "memory" or "a memory" may be composed of more than one different type of memory, and thus may refer to a collective component including one or more types of memory. Any single memory component may be separated into multiple collectively equivalent memory components, and vice versa. Furthermore, while memory may be depicted as separate from one or more other components (such as in the drawings), memory may also be integrated with other components, such as on a common integrated chip or a controller with an embedded memory.

The term "software" refers to any type of executable instruction, including firmware.

The term "sensor" refers to any type of devices suitable for sensing or monitoring and providing information that is representative of or characteristic for a domain of the application.

In the context of this disclosure, the term "process" may be used, for example, to indicate a method. Illustratively, any process described herein may be implemented as a method (e.g., a channel estimation process may be understood as a channel estimation method). Any process described herein may be implemented as a non-transitory computer readable medium including instructions configured, when executed, to cause one or more processors to carry out the process (e.g., to carry out the method).

The apparatuses and methods of this disclosure may utilize or be related to radio communication technologies. While some examples may refer to specific radio communication technologies, the examples provided herein may be similarly applied to various other radio communication technologies, both existing and not yet formulated, particularly in cases where such radio communication technologies share similar features as disclosed regarding the following examples. Various exemplary radio communication technologies that the apparatuses and methods described herein may utilize include, but are not limited to: a Global System for Mobile Communications ("GSM") radio communication technology, a General Packet Radio Service ("GPRS") radio communication technology, an Enhanced Data Rates for GSM Evolution ("EDGE") radio communication technology, and/or a Third Generation Partnership Project ("3 GPP") radio communication technology, for example Universal Mobile Telecommunications System ("UMTS"), Freedom of Multimedia Access ("FOMA"), 3GPP Long Term Evolution ("LTE"), 3GPP Long Term Evolution Advanced ("LTE Advanced"), Code division multiple access 2000 ("CDMA2000"), Cellular Digital Packet Data ("CDPD"), Mobitex, Third Generation (3G), Circuit Switched Data ("CSD"), High-Speed Circuit-Switched Data ("HSCSD"), Universal Mobile Telecommunications System ("Third Generation") ("UMTS (3G)"), Wideband Code Division Multiple Access (Universal Mobile Telecommunications System) ("W-CDMA (UMTS)"), High Speed Packet Access ("HSPA"), High-Speed Downlink Packet Access ("HSDPA"), High-Speed Uplink Packet Access ("HSUPA"), High Speed Packet Access Plus ("HSPA+"), Universal Mobile Telecommunications System-Time-Division Duplex ("UMTS-TDD"), Time Division-Code Division Multiple Access ("TD-CDMA"), Time Division-Synchronous Code Division Multiple Access ("TD-CDMA"), 3rd Generation Partnership Project Release 8 (Pre-4th Generation) ("3GPP Rel. 8 (Pre-4G)"), 3GPP Rel. 9 (3rd Generation Partnership Project Release 9), 3GPP Rel. 10 (3rd Generation Partnership Project Release 10) , 3GPP Rel. 11 (3rd Generation Partnership Project Release 11), 3GPP Rel. 12 (3rd Generation Partnership Project Release 12), 3GPP Rel. 13 (3rd Generation Partnership Project Release 13), 3GPP Rel. 14 (3rd Generation Partnership Project Release 14), 3GPP Rel. 15 (3rd Generation Partnership Project Release 15), 3GPP Rel. 16 (3rd Generation Partnership Project Release 16), 3GPP Rel. 17 (3rd Generation Partnership Project Release 17), 3GPP Rel. 18 (3rd Generation Partnership Project Release 18), 3GPP 5G, 3GPP LTE Extra, LTE-Advanced Pro, LTE Licensed-Assisted Access ("LAA"), MuLTEfire, UMTS Terrestrial Radio Access ("UTRA"), Evolved UMTS Terrestrial Radio Access ("E-UTRA"), Long Term Evolution Advanced (4th Generation) ("LTE Advanced (4G)"), cdmaOne ("2G"), Code division multiple access 2000 (Third generation) ("CDMA2000 (3G)"), Evolution-Data Optimized or Evolution-Data Only ("EV-DO"), Advanced Mobile Phone System (1st Generation) ("AMPS (1G)"), Total Access Communication arrangement/Extended Total Access Communication arrangement ("TACS/ETACS"), Digital AMPS (2nd Generation) ("D-AMPS (2G)"), Push-to-talk ("PTT"), Mobile Telephone System ("MTS"), Improved Mobile Telephone System ("IMTS"), Advanced Mobile Telephone System ("AMTS"), OLT (Norwegian for Offentlig Landmobil Telefoni, Public Land Mobile Telephony), MTD (Swedish abbreviation for Mobiltelefonisystem D, or Mobile telephony system D), Public Automated Land Mobile ("Autotel/PALM"), ARP (Finnish for Autoradiopuhelin, "car radio phone"), NMT (Nordic Mobile Telephony), High capacity version of NTT (Nippon Telegraph and Telephone) ("Hicap"), Cellular Digital Packet Data ("CDPD"), Mobitex, DataTAC, Integrated Digital Enhanced Network ("iDEN"), Personal Digital Cellular ("PDC"), Circuit Switched Data ("CSD"), Personal Handy-phone System ("PHS"), Wideband Integrated Digital Enhanced Network ("WiDEN"), iBurst, Unlicensed Mobile Access ("UMA"), also referred to as also referred to as 3GPP Generic Access Network, or GAN standard), Zigbee, Bluetooth®, Wireless Gigabit Alliance ("WiGig") standard, mmWave standards in general (wireless systems operating at 10-300 GHz and above such as WiGig, IEEE 802.11ad, IEEE 802.11ay, etc.), technologies operating above 300 GHz and THz bands, (3GPP/LTE based or IEEE 802.11p and other) Vehicle-to-Vehicle ("V2V") and Vehicle-to-X ("V2X") and Vehicle-to-Infrastructure ("V2I") and Infrastructure-to-Vehicle ("I2V") communication technologies, 3GPP cellular V2X, DSRC (Dedicated Short Range Communications) communication arrangements such as Intelligent-Transport-Systems, and other existing, developing, or future radio communication technologies.

The apparatuses and methods described herein may use such radio communication technologies according to various spectrum management schemes, including, but not limited to, dedicated licensed spectrum, unlicensed spectrum, (licensed) shared spectrum (such as LSA = Licensed Shared Access in 2.3-2.4 GHz, 3.4-3.6 GHz, 3.6-3.8 GHz and further frequencies and SAS = Spectrum Access System in 3.55-3.7 GHz and further frequencies), and may use various spectrum bands including, but not limited to, IMT (International Mobile Telecommunications) spectrum (including 450-470 MHz, 790-960 MHz, 1710-2025 MHz, 2110-2200 MHz, 2300-2400 MHz, 2500-2690 MHz, 698-790 MHz, 610-790 MHz, 3400-3600 MHz, etc., where some bands may be limited to specific region(s) and/or countries), IMT-advanced spectrum, IMT-2020 spectrum (expected to include 3600-3800 MHz, 3.5 GHz bands, 700 MHz bands, bands within the 24.25-86 GHz range, etc.), spectrum made available under FCC's "Spectrum Frontier" 5G initiative (including 27.5-28.35 GHz, 29.1-29.25 GHz, 31-31.3 GHz, 37-38.6 GHz, 38.6-40 GHz, 42-42.5 GHz, 57-64 GHz, 64-71 GHz, 71-76 GHz, 81-86 GHz and 92-94 GHz, etc.), the ITS (Intelligent Transport Systems) band of 5.9 GHz (typically 5.85-5.925 GHz) and 63-64 GHz, bands currently allocated to WiGig such as WiGig Band 1 (57.24-59.40 GHz), WiGig Band 2 (59.40-61.56 GHz) and WiGig Band 3 (61.56-63.72 GHz) and WiGig Band 4 (63.72-65.88 GHz), the 70.2 GHz-71 GHz band, any band between 65.88 GHz and 71 GHz, bands currently allocated to automotive radar applications such as 76-81 GHz, and future bands including 94-300 GHz and above. Furthermore, the apparatuses and methods described herein can also employ radio communication technologies on a secondary basis on bands such as the TV White Space bands (typically below 790 MHz) where e.g. the 400 MHz and 700 MHz bands are prospective candidates. Besides cellular applications, specific applications for vertical markets may be addressed such as PMSE (Program Making and Special Events), medical, health, surgery, automotive, low-latency, drones, etc. applications. Furthermore, the apparatuses and methods described herein may also use radio communication technologies with a hierarchical application, such as by introducing a hierarchical prioritization of usage for different types of users (e.g., low/medium/high priority, etc.), based on a prioritized access to the spectrum e.g., with highest priority to tier-1 users, followed by tier-2, then tier-3, etc. users, etc. The apparatuses and methods described herein can also use radio communication technologies with different Single Carrier or OFDM flavors (CP-OFDM, SC-FDMA, SC-OFDM, filter bank-based multicarrier (FBMC), OFDMA, etc.) and e.g. 3GPP NR (New Radio), which can include allocating the OFDM carrier data bit vectors to the corresponding symbol resources.

For purposes of this disclosure, radio communication technologies may be classified as one of a Short Range radio communication technology or Cellular Wide Area radio communication technology. Short Range radio communication technologies may include Bluetooth, WLAN (e.g., according to any IEEE 802.11 standard), and other similar radio communication technologies. Cellular Wide Area radio communication technologies may include Global System for Mobile Communications ("GSM"), Code Division Multiple Access 2000 ("CDMA2000"), Universal Mobile Telecommunications System ("UMTS"), Long Term Evolution ("LTE"), General Packet Radio Service ("GPRS"), Evolution-Data Optimized ("EV-DO"), Enhanced Data Rates for GSM Evolution ("EDGE"), High Speed Packet Access (HSPA; including High Speed Downlink Packet Access ("HSDPA"), High Speed Uplink Packet Access ("HSUPA"), HSDPA Plus ("HSDPA+"), and HSUPA Plus ("HSUPA+")), Worldwide Interoperability for Microwave Access ("WiMax") (e.g., according to an IEEE 802.16 radio communication standard, e.g., WiMax fixed or WiMax mobile), etc., and other similar radio communication technologies. Cellular Wide Area radio communication technologies also include "small cells" of such technologies, such as microcells, femtocells, and picocells. Cellular Wide Area radio communication technologies may be generally referred to herein as "cellular" communication technologies.

Unless explicitly specified, the term "transmit" encompasses both direct (point-to-point) and indirect transmission (via one or more intermediary points). Similarly, the term "receive" encompasses both direct and indirect reception. Furthermore, the terms "transmit", "receive", "communicate", and other similar terms encompass both physical transmission (e.g., the transmission of radio signals) and logical transmission (e.g., the transmission of digital data over a logical software-level connection). For example, a processor or controller may transmit or receive data over a software-level connection with another processor or controller in the form of radio signals, where the physical transmission and reception is handled by radio-layer components such as RF transceivers and antennas, and the logical transmission and reception over the software-level connection is performed by the processors or controllers. The term "communicate" encompasses one or both of transmitting and receiving, i.e. unidirectional or bidirectional communication in one or both of the incoming and outgoing directions. The term "calculate" encompass both 'direct' calculations via a mathematical expression/formula/relationship and 'indirect' calculations via lookup or hash tables and other array indexing or searching operations. The term "channel state information" is used herein to refer generally to the wireless channel for a wireless transmission between one or more transmitting antennas and one or more receiving antennas and may take into account any factors that affect a wireless transmission such as, but not limited to, path loss, interference, and/or blockage.

A "machine" may be understood to include any type of mechanical structure that uses (e.g., electrical) power to alter its environment, to apply forces, to control movement, and/or to perform an intended action, e.g., a mechanical structure programmable by a computer. By way of example, a machine may be a driven object with a combustion engine, a reaction engine, an electrically driven object, a hybrid driven object, or a combination thereof. A machine may be or may include a humanoid machine, a non-humanoid machine, an agricultural machine, a machine tool, a moving machine, a stationary machine, a drone, an industrial machine, a medical operating machine, a collectively operating machine, a ground machine, an aerial machine, an aquatic machine, or a mixture thereof, among others.

The term "automated machine" as used herein (also referred to as an at least partially autonomous machine or as a robot) may describe a machine capable of managing one or more tasks (also referred to as task performance) at least partially without human intervention, input, and/or control. Examples of automated machines may include a hybrid machine, a human assisted machine, and/or an autonomous machine. The term "autonomous machine" as used herein (also referred to as autonomous robot) may describe a (e.g., automated) machine capable of managing one or more tasks (also referred to as task performance) without human intervention, input, and/or control. Exemplary components of managing task may include: managing one or more physical tasks (also referred to as task management), planning the task performance, organizing the task performance, scheduling the task performance, switching between two tasks, competing for one or more task, assigning one or more tasks, completing one or more tasks, reporting about completion of the one or more tasks, negotiation of the allocation of one or more tasks (e.g., between multiple autonomous machines), monitoring the progress of one or more tasks, navigate the autonomous machine to one or more positions of one or more tasks (e.g., at which the one or more task require a physical manipulation), etc.

References made herein to robots or automated machines may be understood as exemplarily and may analogously apply to any type of autonomous machine, and vice versa. References made herein with regard to one or more autonomous machines may analogously apply to one or more automated machines. According to various aspects, the task management may be collaborative, e.g., when multiple robots are allocated to one or more tasks. The robots implementing the collaborative task management may be configured to exchange data related to the task management. In this disclosure, both of the automated machines and autonomous machines may be referred to as autonomous machines.

The task performance may include processing one or more workpieces, e.g., by adding material to the workpiece, removing material from the workpiece, transforming the workpiece, moving the workpiece, picking up the workpiece, putting down the work piece, and the like. The autonomous machine may implement one or more task performance models, e.g., a respective controller of the autonomous machine may implement the one or more task performance models. A task performance model may be configured to control the task performance by the autonomous machine based on input data, e.g., to convert the input data into control instructions. The controller may be configured to transmit the control instructions within the autonomous machine, e.g., in accordance with an in-machine communication protocol (e.g., a fieldbus communication protocol) and/or to one or more actuators of the autonomous machine. Generally, a task performance model may be (e.g., at least in part) rule based and/or may be (e.g., at least in part) based on machine learning.

In accordance with various aspects, a task performance model may operate based on a policy. The task performance model may control the task performance by the autonomous machine based on the policy. The policy may include any type of information that may provide a guidance, which can be at various levels, to the task performance model to manage the one or more tasks. The policy may include a set of rules in a rule-based task performance model. The policy may include machine learning policies in a machine-learning based task performance model. The policy may include one or more parameters (e.g.) that cannot be adjusted. The policy may include one or more adjustable parameters. In accordance with various aspects of this disclosure, the task performance may be optimized by adjusting the one or more adjustable parameters (which may be referred to as policy parameters in this disclosure). In accordance with various aspects of this disclosure, an automated machine may provide various task performances based on various policies.

Examples of the input data may include: data that one or more of the sensors of the autonomous machine sensed, data that the autonomous machine stores (e.g., in a database), data indicating instructions provided to the autonomous machine (e.g., data that an operator or a group leader receives), data about an affiliation of the autonomous machine to a group (also referred to as group affiliation), data about an assignment of the autonomous machine to one or more tasks of the group, data exchanged between multiple autonomous machines (e.g., data transmitted from another autonomous machine of the group), and/or data about a task (also referred to as task data). The control instructions may be understood as in-machine instructions to control one or more actuators of the autonomous machine. Examples of the one or more actuators of the autonomous machine may include: one or more actuators configured to cause a motion of the autonomous machine, one or more actuators configured to actuate a tool of the autonomous machine, one or more actuators configured to move the tool (also referred to as effector) of the autonomous machine (e.g., relative to the one or more actuators configured to cause a motion of the autonomous machine), one or more actuators being part of the kinetic chain (e.g., a robotic arm) of the autonomous machine.

Performing one or more tasks may include one or more actions of the autonomous machine, e.g., one or more spatially distributed actions (e.g., a spatial sequence of actions) and/or one or more spatially chronological actions (e.g., in a chronologic sequence of operations). The spatial distribution of multiple actions (also referred to as machine actions) may indicate, where (i.e., with which spatial relation) and/or in which direction the autonomous machine provides the one or more actions, i.e. in which corresponding spatial position (i.e. position and/or orientation) the autonomous machine or its tool is located.

The one or more tasks may be represented (e.g., logically) by data (also referred to as task data). A task may refer to one task or a group of multiple tasks, which are related to each other, e.g., contextually or logically related to each other (for example, tasks directed to the fabrication of a certain product, tasks directed to the exploration of a certain are, and the like). The task data may be a formal representation of the task. Examples of the task data may include: data identifying each task (also referred to as task identifier), data organizing each task (e.g., spatial and/or chronological data), data indicating the criteria under which a task is fulfilled, data indicating goals of each task, data identifying criteria for triggering, terminating, or maintaining a task, etc.

Furthermore, the task data may include a task logic, which logically links tasks, priorities, criteria, conditions, and/or tasks and/or which implements a sequence (e.g., a flow chart), according to which the task is executed. For example, the task logic may organize the task hierarchically, e.g., into hierarchical levels, hierarchical groups, subtasks, and the like. For example, a task may include multiple subtasks on a lower hierarchical level, which may be, but not need to be, prioritized, contextual based, and/or conditional. Viewed from the hierarchical level of the subtask, the subtask may also be referred to as task, and may include, but not need to include, multiple subtasks. For example, the task logic may organize the task in accordance with conditional aspects and/or contextual aspects. For example, the task logic may define conditional tasks, e.g., by defining conditions/requirements to be fulfilled for starting a task performance and/or for ending a task performance.

Herein the term "collaborate", "collaborative", "collaboration" refers to entities, such as devices (a plurality of autonomous machines), methods and functions, as examples, participating to accomplish a task. Examples of the collaborative entities may include various types of agents or actors, such as automated machines (e.g., partially of fully autonomous machines), humans, non-automated machines, or non-autonomous machines. Multiple entities (e.g., autonomous machines) participating in the task may be affiliated (e.g., assigned) to a group (herein also referred to as group, swarm, team, or as a cluster), e.g., being members (also referred to as agents or as nodes) of the group. Multiple autonomous machines participating in the task may be affiliated (e.g., assigned) to a group (e.g. cluster) of autonomous machines (herein also referred to as group, swarm, team or cluster), e.g., being members (also referred to as agents or as nodes) of the group of autonomous machines. Each group (e.g., of autonomous machines) may be entrusted with one or more tasks.

References made herein with respect to a group of autonomous machines may analogously apply to a group of entities, e.g., including various types of agents or actors, such as automated machines (e.g., partially of fully autonomous machines), humans, non-automated machines, or non-autonomous machines. The autonomous machine may be configured to collaborate with one or more other autonomous machine, e.g., by implementing one or more protocols (also referred to as collaboration protocols). Examples of collaboration protocols may include: a protocol for group management (also referred to as group management protocol), a protocol for communication (e.g., data exchange) between members of a group of collaborating autonomous machines (also referred to as group communication protocol), a protocol for managing tasks (also referred to as task management protocol).

Generally, a protocol may define rules that indicate the format, syntax, semantics and/or synchronization of information, e.g., of information transfer (e.g., exchange), information storage, information processing, and the like. For example, the autonomous machine may form, join and/or leave a group in accordance with the group management protocol. For example, the autonomous machine may be configured to communicate with other members of the group in accordance with the group communication protocol. For example, the autonomous machine may be configured to exchange sensed data or exchange model data with other members of the group in accordance with the group communication protocol (also referred to as data exchange protocol). For example, a group identifier used to route a message generated in accordance with the group communication protocol to the group.

The automated machine may be configured to broadcast the message to all members of the group, and/or a member identifier or topical filter may route the message to individual members of the group. For example, the autonomous machine may be configured to manage the task performance in accordance with the task management protocol, e.g., synchronizing task data and/or the status (e.g., the progress and/or accomplishment) of one or more tasks.

The term "target information" may indicate the respective information of interest about the environmental property. The target information may include various types of information about the environment of the sensor, which are based on the sensing process that the sensor performs, e.g., a result thereof. According to various aspects, the target information may include information about one or more logic, geometric, kinematic, mechanical, radiometric (e.g., photometric), thermodynamically, electrical and/or chemical properties of the environment of the sensor, which are based on the sensing process that the sensor performs, e.g., on a result thereof. This is reflected by the type of the target information, which may be a logical type, geometrical type, kinematical type, mechanical type, radiometrical type (e.g., photometric type), thermodynamical type, electrical type and/or chemical type.

The term "result" with regard to a sensing process (also referred to as sensing result or as result of the sensing process) may refer to an interim stage of data that the sensing chain processes and/or to the target information as output of the processing chain. Examples of the sensing result may include: sensor raw data, an aggregation of raw data, pre-processed (e.g., filtered and/or converted) raw data, a quantized result of processing the sensor raw data, e.g., including numerical information about the sensed property (e.g., one or more values of the sensed property), a classified result of processing the sensor raw data, an estimation made based on the raw data (e.g., output of a model), etc. Examples of the result of an image acquisition as sensing process, may include pixel raw data, the image data based on the raw data, a video, the result of an object recognition based on the image data, a spectral composition, a light intensity value, a distance determined based on the image data, etc.

Various aspects herein may utilize one or more machine learning models to perform or control functions of the machine (or other functions described herein). The term "model" used herein may be understood as any kind of algorithm, which provides output data based on input data provided to the model (e.g., any kind of algorithm generating or calculating output data based on input data). A computing system may execute a machine learning model to progressively improve the performance of a specific task. In some aspects, parameters of a machine learning model may be adjusted during a training phase based on training data. A trained machine learning model may be used during an inference phase to make estimations or decisions based on input data. In some aspects, the trained machine learning model may be used to generate additional training data. An additional machine learning model may be adjusted during a second training phase based on the generated additional training data. A trained additional machine learning model may be used during an inference phase to make estimations or decisions based on input data.

The machine learning models described herein may take any suitable form or utilize any suitable technique (e.g., for training purposes). For example, any of the machine learning models may utilize supervised learning, semi-supervised learning, unsupervised learning, or reinforcement learning techniques.

In supervised learning, the model may be built using a training set of data including both the inputs and the corresponding desired outputs (illustratively, each input may be associated with a desired or expected output for that input). Each training instance may include one or more inputs and a desired output. Training may include iterating through training instances and using an objective function to teach the model to estimate the output for new inputs (illustratively, for inputs not included in the training set). In semi-supervised learning, a portion of the inputs in the training set may be missing the respective desired outputs (e.g., one or more inputs may not be associated with any desired or expected output).

In unsupervised learning, the model may be built from a training set of data including only inputs and no desired outputs. The unsupervised model may be used to find structure in the data (e.g., grouping or clustering of data points), illustratively, by discovering patterns in the data. Techniques that may be implemented in an unsupervised learning model may include, e.g., self-organizing maps, nearest-neighbor mapping, k-means clustering, and singular value decomposition.

Reinforcement learning models may include positive feedback (also referred to as reward) or negative feedback to improve accuracy. A reinforcement learning model may attempt to maximize one or more objectives/rewards. Techniques that may be implemented in a reinforcement learning model may include, e.g., Q-learning, temporal difference (TD), and deep adversarial networks.

Various aspects described herein may utilize one or more classification models. In a classification model, the outputs may be restricted to a limited set of values (e.g., one or more classes). The classification model may output a class for an input set of one or more input values. An input set may include sensor data, such as image data, radar data, LIDAR data, and the like. A classification model as described herein may, for example, classify environmental conditions, such as weather conditions and the like. References herein to classification models may contemplate a model that implements, e.g., any one or more of the following techniques: linear classifiers (e.g., logistic regression or naive Bayes classifier), support vector machines, decision trees, boosted trees, random forest, neural networks, or nearest neighbor.

Various aspects described herein may utilize one or more regression models. A regression model may output a numerical value from a continuous range based on an input set of one or more values (illustratively, starting from or using an input set of one or more values). References herein to regression models may contemplate a model that implements, e.g., any one or more of the following techniques (or other suitable techniques): linear regression, decision trees, random forest, or neural networks.

A machine learning model described herein may be or may include a neural network. The neural network may be any kind of neural network, such as a convolutional neural network, an autoencoder network, a variational autoencoder network, a sparse autoencoder network, a recurrent neural network, a deconvolutional network, a generative adversarial network, a forward thinking neural network, a sum-product neural network, and the like. The neural network may include any number of layers. The training of the neural network (e.g., adapting the layers of the neural network) may use or may be based on any kind of training principle, such as backpropagation (e.g., using the backpropagation algorithm).

For example, the controller of an autonomous machine may be configured to train the task performance model based on training data. The training data may include the control instructions, a result of the task performance (also referred to as an actual result), and/or a predefined result (also referred to as expected result or target result). For example, the controller may be configured to determine the result of the task performance by sensing the environment of the machine. For example, the predefined result may represent an optimum result or a range of results that are acceptable. Said more generally, the training data may indicate whether the result of the task performance fulfills a predefined criterion, e.g., by comparing the actual result with the predefined result. For example, the criterion may be fulfilled when a deviation of the actual result from the predefined result is zero.

Generally, the actual result and/or the predefined result may be parameterized, e.g., represented by data (also referred to as result data) including one or more parameters as information about the result. For example, the result data may include sensed parameters, such as physical, electrical and/or chemical properties of the result.

Throughout the present disclosure, the following terms may be used as synonyms: parameter set, model parameter set, safety layer parameter set, automated motion model parameter set, policy parameters, and/or the like. These terms may correspond to groups of values used to implement one or more models for directing an autonomous machine or a group of autonomous machines to operate according to the manners described herein.

Furthermore, throughout the present disclosure, the following terms may be used as synonyms: parameter, model parameter, safety layer parameter, and/or automated movement model parameter, a policy parameter, and/or the like, and may correspond to specific values within the previously described sets.

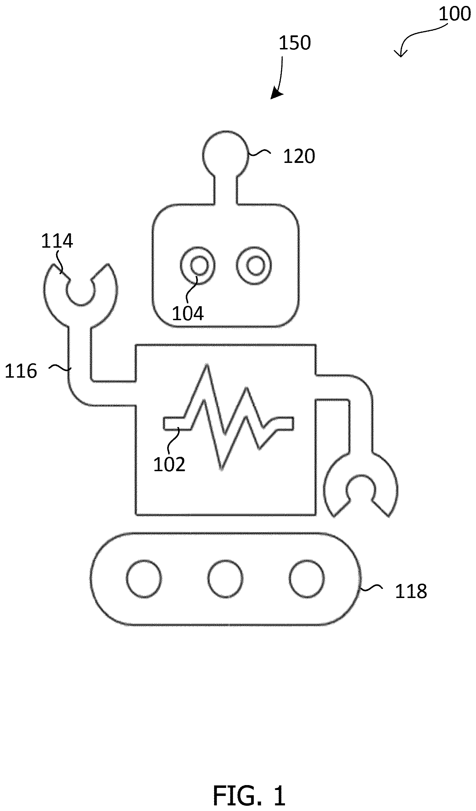

FIG. 1 shows an example of an autonomous machine 150 in accordance with various aspects 100 of the present disclosure. In some aspects, the machine 150 may include one or more processors 102; one or more sensors 104; one or more effectors 114; one or more kinetic chains 116 (e.g., holding an effector); one or more propulsion devices 118; and/or one or more communication devices 120.

A sensor (also referred to as detector) may be understood as a transducer that is configured to qualitatively or quantitatively sense a property of its environment (also referred to as environmental property) corresponding to the sensor type, e.g., a geometric, kinematic, mechanical, radiometric (e.g., photometric), thermodynamically, electrical and/or chemical property. The sensed quantity is the physical quantity, to which a sensing process using the sensor is directed. Depending on the complexity of the sensor's environment to be sensed, the sensor may be configured to distinguish only between two states of the sensed quantity or to distinguish between more than two states of the sensed quantity. A sensor may be part of a specific processing chain (also referred to as sensing chain), which includes a corresponding infrastructure (e.g., including processor, storage medium, and/or bus system or the like).

The sensing chain may be configured to operate the corresponding sensor (e.g., water sensor, pressure sensor, and/or actuation sensor), to process its sensed quantity as input, and to provide a target information as output, which represents the input. According to various aspects, the one or more processors 102 (e.g., being components of a controller) may be configured to implement at least a part of the sensing chain. It is noted that the sensing chain may optionally include (e.g., wireless and/or wired) data exchange, e.g., between various nodes of a network-based sensing chain. For example, the sensing chain may be configured to output the sensing result via an electrical signal (also referred to as sensor signal) or communicate the sensing result (e.g., wirelessly and/or via wire) to another component of the sensing chain or to a further communication device (e.g., of a further autonomous machine, a controlling entity).

According to various aspects, the sensing result (also referred to as sensor data) may include sensor raw data, quantized information about the sensed property (e.g., one or more values of the sensed property), or a result of processing the information about the sensed property and/or the sensor raw data. For example, the result of an image acquisition as exemplarily sensing process, may include pixel raw data, the image data based on the raw data, the result of an object recognition based on the image data, a spectral composition, a light intensity value, a distance determined based on the image data, etc. The result of the sensing process may include various types of information about an environment of the sensor, which is based on the sensing process that the sensor may perform. According to various aspects, the result of the sensing process may include information about one or more logic, geometric, kinematic, mechanical, radiometric (e.g., photometric), thermodynamically, electrical, and/or chemical properties of the environment of the sensor, which are determined based on the sensing process that the sensor may perform. Analogously, the type of information may be a logic type, geometric type, kinematic type, mechanical type, radiometric type (e.g., photometric type), thermodynamic type, electric type, and/or chemical type.

According to various aspects, the sensing chain (e.g., the one or more processors 102) may be configured to obtain the same sensing result by sensing various environmental properties, and/or various sensors may be configured to obtain the same sensing result. For example, the sensing chain (e.g., the one or more processors 102) may be configured to determine a distance of the autonomous machine from an object based on a radar sensor, a LIDAR sensor, or also by processing image data from a camera, e.g., stereographic image data. For example, the sensing chain (e.g., the one or more processors 102) may be configured to determine a temperature based on a resistive temperature sensor or based on a radiometric sensor, e.g., based on a spectral composition that the radiometric sensor sensed.

Generally, each sensor 104 may be configured to sense an actual condition (also referred to as actual state), e.g., the condition at the point of time of the sensing process. Examples of the one or more sensors 104 may be configured to sense the actual condition of the machine 150 (also referred to as operational condition), wherein other examples of the one or more sensors 104 may be configured to sense the actual condition of the environment of the machine 150 (also referred to as environmental condition), e.g., to which the one or more sensors 104 are exposed.

Examples of sensing the actual condition of the machine 150 may include: sensing the temperature of the machine 150, sensing the position of an effector, sensing the position of one or more nodes of the kinetic chain 116, sensing the position and/or orientation of the machine 150, sensing the speed of the machine, sensing an operation and/or status of the effector, e.g., sensing a force that the effector may generate, sensing a fluid flow that the effector may generate, generating an electrical power output that the effector may generate. Examples of sensing the environmental condition of

EP 4 202 591 B1

the machine 150 may include: sensing an object in the vicinity of the machine 150, e.g., one or more properties of the object; sensing a progress of the task performance; sensing radiation in the vicinity of the machine 150, e.g., electromagnetic radiation or particle radiation; sensing sound/acoustics. Examples of the object may include: the workpiece that machine 150 may process, a human, another machine; a fluid, a gas, a solid. Examples of the properties of the object may include: a distance of the object from the machine; a position of the object; a temperature of the object; a texture of the object; a chemical composition of the object; a movement of the object; etc.

Examples of the one or more sensors 104 include one or more optoelectronic sensors 105 (e.g., providing one or more image acquisition devices), one or more position sensors 106, one or more speed sensors, one or more distance sensors 108, e.g., one or more radar sensors and/or one or more LIDAR sensors, one or more temperature sensors 110, one or more force sensors 112.

Examples of the one or more propulsion devices 118 may include one or more ground propulsion devices 118, one or more water propulsion devices 118, and/or one or more air propulsion devices 118. Exemplary components of a propulsion device 118 may include one or more motors; one or more rollers; one or more tires; one or more continuous tracks; one or more propellers; and the like. Exemplary components of a communication device 120 may include one or more (e.g., wireless and/or wired) transceivers 208, 210, 212; one or more antennas (also referred to as antenna system); one or more amplifiers, one or more filters, one or more modulators, one or more demodulators, one or more basebandprocessors, one or more signal processors, one or more memories.

Optionally, one or more components of the autonomous machine 150 may be configured exchangeable (also referred to as exchangeable components). The autonomous machine may be configured to unmount an exchangeable component and mount a further exchangeable component in place of the unmounted component (also referred to as selfchange process). For example, at least one effector of the autonomous machine 150 may be configured to as exchangeable component. In this case, the kinetic chain 116 holding the effector may be configured to release (e.g., unmount) the effector and mount another effector (also referred to as change tools).

As outlined below in more detail, the one or more processors 102 may be configured to generate one or more messages in accordance with a (e.g., wireless and/or wired) communication protocol and provide the generated one or more messages to the one or more communication devices 120. The one or more communication devices 120 may be configured to send the one or more messages in accordance with a (e.g., wireless and/or wired) communication protocol. Analogously, the one or more communication devices 120 may be configured to receive one or more messages in accordance with a (e.g., wireless and/or wired) communication protocol and provide the received one or more messages to the one or more processors 102. The one or more processors 102 may be configured to process the one or more messages.

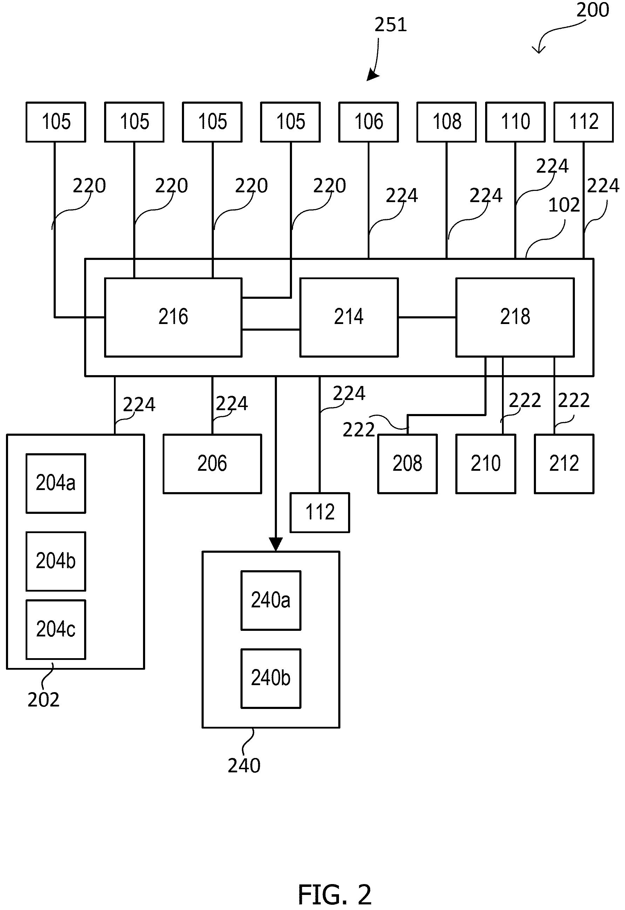

In some aspects, the machine 150 may include a control system 251 (as described with respect to FIG. 2 below). It is appreciated that machine 150 and control system 251 are exemplary in nature and may thus be simplified for explanatory purposes. Locations of elements and relational distances (as discussed above, the figures are not to scale) are provided as examples and are not limited thereto. The control system 251 may include various components depending on the requirements of a particular implementation.

FIG. 2 shows various exemplary electronic components of a machine, namely control system 251, in accordance with various aspects 200 of the present disclosure. In some aspects, the control system 251 may include one or more processors 102, one or more image acquisition devices 105 (e.g., one or more cameras), one or more position sensors 106 (e.g., a Global Navigation Satellite System (GNSS), a Global Positioning System (GPS), among others) one or more distance sensors 108, e.g., one or more radar sensors and/or one or more LIDAR sensors, one or more temperature sensors 110, one or more force sensors 112. According to at least one aspect, control system 251 may further include one or more memories 202, one or more map databases 204a, one or more task databases 204b, one or more models 204c, one or more input/output interfaces 206 (e.g., user interfaces), and/or one or more (e.g., wireless and/or wired) transceivers 208, 210, 212. Exemplary components of the one or more input/output interfaces 206 include one or more displays, one or more touch screens, one or more microphones, one or more loudspeakers, one or more buttons, and/or switches, etc.

The (e.g., wireless and/or wired) transceivers 208, 210, 212 may, in some aspects, be configured according to the same, different, or any combination thereof radio communication protocols or standards. By way of example, a (e.g., wireless and/or wired) transceiver (e.g., a first wireless transceiver 208) may be configured in accordance with a Short Range mobile radio communication standard (e.g., Bluetooth, Zigbee, among others). As another example, a (e.g., wireless and/or wired) transceiver (e.g., a second wireless transceiver 210) may be configured in accordance with a Medium or Wide Range mobile radio communication standard (e.g., 3G (e.g., Universal Mobile Telecommunications System - UMTS), 4G (e.g., Long Term Evolution - LTE), and/or 5G mobile radio communication standard in accordance with corresponding 3GPP (3rd Generation Partnership Project) standards, among others). As a further example, a (e.g., wireless and/or wired) transceiver (e.g., a third wireless transceiver 212) may be configured in accordance with a Wireless Local Area Network communication protocol or standard (e.g., IEEE 802.11 , 802.11, 802.11a, 802.11b, 802.11g, 802.11n, 802.11p, 802.11-12, 802.11ac, 802.11ad, 802.11ah, among others). The one or more (e.g., wireless and/or wired) transceivers 208, 210, 212 may be configured to transmit signals via the antenna system over an air interface.

In some aspects, the one or more processors 102 may include an application processor 214, an image processor 216, a communication processor 218, a signal processor, and/or any other suitable processing device. Image acquisition device(s) 105 may include any number of image acquisition devices and components depending on the requirements of a particular application. Image acquisition devices 105 may include one or more image capture devices, e.g., cameras, CCDs (charge coupling devices, or any other type of image sensor).

In at least one aspect, the control system 251 may also include one or more data interfaces communicatively connecting the one or more processors 102 to other components of the control system 251. For example, one or more the data interfaces may be configured to exchange data in accordance with a fieldbus communication protocol or another in-machine communication protocol. For example, the one or more data interfaces may include a first data interface, e.g., including any wired and/or (e.g., wireless and/or wired) first link 220 or first links 220 configured to transmit image data that the one or more image acquisition devices 105 acquire to the one or more processors 102 (e.g., to the image processor 216). For example, the one or more data interfaces may include a second data interface, e.g., including any wired and/or (e.g., wireless and/or wired) second link 222 or second links 222 configured to transmit radio transmitted data that the (e.g., wireless and/or wired) transceivers 208, 210, 212 may acquire to the one or more processors 102, e.g., to the communication processor 218. For example, the one or more data interfaces may include a third data interface 224, e.g., including any wired and/or (e.g., wireless and/or wired) third link 224 or third links 224, coupled to the one or more position sensor 106 and/or to the one or more distance sensors 108 and/or to the one or more temperature sensors 110 and/or to the one or more force sensors 112.

Such data transmissions (e.g., exchange) may also include communications (e.g., one-way or two-way) between the machine 150 and one or more other (target) machines in an environment of the machine 150 (e.g., to facilitate coordination of the task performance by, e.g., including the navigation of, the machine 150 in view of or together with other (e.g., target) machines in the environment of the machine 150), or even a broadcast transmission to unspecified recipients in a vicinity of the transmitting machine 150.

In accordance with various aspects of this disclosure, the data transmissions may also include communications between the machine and one or more controlling entities (e.g. the device 400) especially with respect to setting the task performance model (e.g. receiving operation policies, receiving control instructions for deployment, etc.), and provision information with respect to the environment data to be obtained (e.g. transmitting sensor data, or the sensing result).

One or more of the transceivers 208, 210, 212 may be configured to implement the group communication protocol (e.g., including a data exchange protocol, e.g., a wireless data exchange protocol, and/or a wired data exchange protocol), and optionally one or more other communication protocols. In some aspects, the group communication protocol may include a proprietary (e.g., wireless and/or wired) communication protocol or may be a proprietary (e.g., wireless and/or wired) communication protocol. In some aspects, the group communication protocol may be an application layer protocol, e.g., defining the format, syntax, and/or semantics of the load part of a message generated in accordance with a (e.g., wireless and/or wired) communication protocol.

Each processor 214, 216, 218 of the one or more processors 102 may include various types of hardware-based processing devices. Exemplary components of each processor 214, 216, 218 may include: a microprocessor, pre-processors (such as an image preprocessor), graphics processors, a central processing unit (CPU), support circuits, digital signal processors, integrated circuits, memory, or any other types of devices suitable for running applications and for sensor data processing and analysis. In some aspects, each processor 214, 216, 218 may include any type of single or multi-core processor, mobile device microcontroller, central processing unit, etc. These processor types may each include multiple processing units with local memory and instruction sets. Such processors may include video inputs for receiving image data from multiple image sensors and may also include video out capabilities.

Any of the processors 214, 216, 218 disclosed herein may be configured to perform certain functions in accordance with program instructions which may be stored in a memory of the one or more memories 202. In other words, a memory of the one or more memories 202 may store software that, when a processor (e.g., the one or more processors 102) executes, controls the operation of the system, e.g., of the control system 251. A memory of the one or more memories 202 may store one or more databases and image processing software, as well as a trained system, such as a neural network, or a deep neural network, for example. The one or more memories 202 may include any number of random access memories, read-only memories, flash memories, disk drives, optical storage, tape storage, removable storage, and other types of storage.

In some aspects, the control system 251 may further include components such as a speed sensor (e.g., a speedometer) for measuring a speed of the machine 150. The control system may also include one or more accelerometers (either single axis or multiaxis) (not shown) for measuring accelerations of the machine 150 along one or more axes. The control system 251 may further include additional sensors or different sensor types such as an ultrasonic sensor, a thermal sensor, one or more radar sensors 110, one or more LIDAR sensors 112 (which may be integrated in the head lamps of the machine 150), and the like.

The one or more memories 202 may store data, e.g., in a database or in any different format. The one or more processors 102 may be configured to process sensory information (also referred to as sensor data), such as images, radar signals, depth information from LIDAR, temperature values or stereo processing of two or more images) of the environment of the machine 150 together with position information, such as a GPS coordinate, a machine's ego-motion, etc., to determine a current location of the machine 150 relative to the known landmarks, and refine the determination of the machine's location. Certain aspects of this technology may be included in a localization technology such as a mapping and routing model.

The map database 204 may include any type of database storing (digital) map data for the machine 150, e.g., for the control system 251. The map database 204 may include data relating to the position, in a reference coordinate system, of various (e.g., outdoor or indoor) items, including roads, buildings, walls, topographic features (e.g., stairs), geographic features, rooms, points of interest, spatial information of a task, docks, etc. In some aspects, a processor of the one or more processors 102 may download (e.g., some or all) information of the map database 204 over a (e.g., wireless and/or wired) data connection to a communication network (e.g., over a cellular network and/or the Internet, etc.). In some aspects, a processor of the one or more processors 102 may be configured to determine, e.g., form and/or update, (e.g., some or all) information of the map database 204, e.g., based on sensing the environmental condition by the one or more sensors 104. In some aspects, the map database 204 may store a sparse data model including polynomial representations of the environment of the machine 150.

In some aspects, the control system 251 may include a task database. Exemplary components of the task database may include task data, a task list, a task status, a task allocation, achievement parameters, target results, etc. Illustratively, the task database may provide and/or store information about a task of the cluster, to which the machine 150 is affiliated. Some information of the task database (e.g., some task data) may be provided to the machine 150, e.g., one or more other members of the cluster and/or a central task controlling authority may provide the information of the task database. The machine 150 may provide some information of the task database (e.g., some task data), e.g., to one or more other members of the team and/or to a central task controlling authority. The machine 150 may update and/or form some information of the task database (e.g., some task data), e.g., in accordance with a status of the task and/or based on a sensing result of the machine 150.

Furthermore, the control system 251 may include a task performance model 204b, e.g., an automated system may implement the task performance model 204b. By way of example, the control system 251 may include (e.g., as part of the task performance model) a computer implementation of a formal model of the machine or its environment. By way of example, the control system 251 may include (e.g., as part of the task performance model) a safety performance model, a task interpretation model and/or a machine control model. A task performance model may be or include a mathematical model formalizing an interpretation of applicable task performance policies, safety policies, operation policies, task data, etc., e.g., being applicable to autonomous machines. It is noted that one or more of the detailed components of the task performance model may be implemented monolithically or separately from each other, e.g., by separate applications that the one or more processors may execute.

For example, the safety performance model may be configured to achieve, e.g., three goals: first, the interpretation of safety policies should be sound in the sense that it complies with how humans interpret the safety policies; second, the interpretation should lead to a useful task performance, meaning it will lead to an agile task performance rather than an overly-defensive task performance which inevitably would confuse other agents (e.g., humans and/or machines) and will obstruct accomplishing the task and in turn limit the scalability of system deployment; and third, the interpretation should be efficiently verifiable in the sense that it can be rigorously proven that the autonomous machine correctly implements the interpretation of the safety policies. The safety performance model, illustratively, may be or include a mathematical model for safety assurance that enables identification and performance of proper responses to dangerous situations such that self-perpetrated accidents can be avoided.

For example, the task interpretation model may be configured to determine a formal formulation of performance steps the machine may perform, e.g., based on information about one or more tasks allocated to the machine and/or based on the target performance. The conversion may be configured to lead to an efficient task performance and to a result, which meets the target performance as best as possible, e.g., to accomplish the task.

For example, the machine control model may be configured to determine useful actions that the machine may take leading to a useful task performance, e.g., based on the performance steps and/or the model of the machine and/or its environment. For example, the machine control model may generate the control instructions based on a model of the kinetic chain of the machine, the available effectors of the machine, the reachable position of the machine, etc.

The control system 251 may generate data to control or assist to control the engine control unit (ECU) and/or other components of the machine 150 to directly or indirectly control the driving of the machine 150.

In some aspects, the control system 251 may include a driving device 240 configured to drive one or more actuators of the autonomous machine, e.g., one or more actuators of the kinematic chain of the autonomous machine 150 and/or one or more actuators of the one or more propulsion devices 118. For example, the driving device 240 may include one or more amplifiers 240a and/or one or more energy storages 240b. Examples of energy storages 240b may include any storage capable to storing energy (in a certain form, e.g., such as electrically, magnetically, chemically, and the like) and convert the stored energy in electrical power. Examples of the amplifiers 240a may include any voltage-to-voltage converter providing an operation voltage of the one or more actuators based on the electrical supply power and based on a control signal received from the one or more processors 102.

As described above, the machine 150 may include the control system 251 as also described with reference to FIG. 2. The machine 150 may include the one or more processors 102 e.g. integrated with or separate from an engine control unit (ECU) of the machine 150. The control system 251 may in general generate data to control or assist to control the ECU and/or other components of the machine 150 to directly or indirectly control the driving of the machine 150.

Although the following aspects will be described in association with the above detailed models, any other model may be provided in alternative implementations.

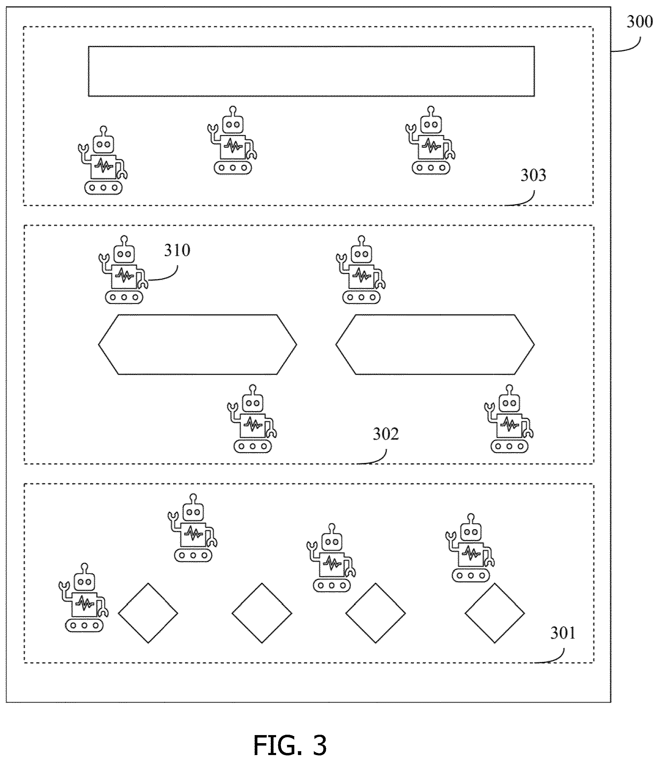

FIG. 3 shows an exemplary illustration of an environment including autonomous or automated machines (as will be referred to as autonomous machines collectively in this disclosure) in accordance with various aspects of this disclosure. The environment is depicted as it includes a number of autonomous machines 310. Furthermore, the environment is depicted as it includes a plurality of sections 301, 302, 303, and within each section a cluster of autonomous machines operate to perform a task (i.e. one or more tasks) assigned for the cluster of autonomous machines. In this illustrative example, a first cluster of autonomous machines perform their tasks in a first section 301, a second cluster of autonomous machines perform their tasks in a second section 302, and a third cluster of autonomous machines perform their tasks in a third section 303, however, this is only provided for illustrative purposes, and autonomous machines of each cluster may also be located in other sections or may move to other sections to perform their tasks. Each cluster of autonomous machines may perform an input task based on an operation policy.

In this example, the first cluster of autonomous machines may perform a first input task based on a first operation policy, the second cluster of autonomous machines may perform a second input task based on a second operation policy, and the third cluster of autonomous machines may perform a third input task based on a third operation policy. Each operation policy may include one or more policy parameters associated with the respective policy to configure various aspects of the respective operation policy. In various examples, each cluster may perform various assigned tasks for the respective cluster based on the input task.

For example, the first cluster of autonomous machines may perform a task with respect to a conveyor belt pick and place task where the first cluster of autonomous machines pick moving objects from a conveyor belt and place it on a tray mounter on a transport robot, the second cluster of autonomous machines may perform a task with respect to an assembly operation in which the second cluster of autonomous machines sequentially sort and palletize target objects onto a pallet, and the third cluster of autonomous machines may perform a task with respect to a store, in which the third cluster of autonomous machines may store the pallets onto a shelf. These examples are only provided for the purpose of illustration, and they should not be taken as limiting.

In accordance with various aspects of this disclosure, a device (e.g. a central task controlling entity) may determine and/or control various aspects with respect to the cluster of autonomous machines, their respective tasks, and the deployment of the autonomous machines in each cluster to the environment based on the input task. In various examples, the device may include a computing device. The computing device may be any type of computing device, including a standalone computing device, that may also be implemented in the environment of the respective system, an edge computing device that may be implemented as an edge computing device or as an edge computing node (edge computing unit) or a combination of edge computing nodes, or a cloud computing device. In various examples, the device may be a part or a portion of another device.

The autonomous machines may employ machine-learning based task performance models, and such applications may include a cluster of autonomous machines operating together to collaboratively perform a range of complex tasks. Examples of these applications include autonomous assembly lines in a robotic factory, a robotic warehouse, and smart retail where autonomous machines may jointly pick up, sort, transport, store/ship objects, etc. It may be desirable to employ a machine-learning based task performance models (e.g. Reinforcement Learning (RL)) to learn and execute the multiple autonomous machine actions and behavior for various tasks in comparison to employing traditional planning and controlbased approaches. A machine-learning based task performance model may be helpful in terms of adaptability and reconfigurability to new tasks and diverse scenarios, ease of scalability of an environment to a large number of autonomous machine clusters & tasks, ease of field deployment, avoiding manual-intensive programming, etc.

There may be various challenges to enable and realize an artificial intelligence / machine learning (AI/ML) based (e.g. RL-based) multi-robot multi-task system in practice. One of the challenges may include learning of Reinforcement Learning policies for the entire system at once, wherein multiple clusters of autonomous machines operate and coordinate in a seamless manner might be difficult due to large state-space dimensionality, highly sparse rewards, etc. Furthermore, it may not be easy for a typical user or operator to create an elaborate environment constituted with multiple AI/ML-based autonomous machine sub-systems as it requires specialized knowledge of the AI/ML, and further knowledge in terms of autonomous machine simulation tools and models, etc. The user or operator may need a single unified model of the factory environment that may include all the various RL-based robot sub-systems or clusters functioning together for system-level validation, debugging, workflow optimization, and deployment. There may be also additional challenges such as duplication of functions across different AI/ML models in a library that need to be resolved, enabling automatic transformations of robot actions in each model onto a single base coordinate system, enabling time-synchronization and coordination of actions between different autonomous machines across different clusters. It may be desirable to obtain a factory system including several AI/ML-based autonomous machine clusters that are capable working together on multiple tasks as required in a typical workflow.

It may further be desirable to train the autonomous machines or clusters of autonomous machines for various predefined tasks with an intention to optimize AI/ML based task performance model with an offline training, then integrate pre-trained AI/ML based task performance models. It may further be desirable for an operator to use an interface to select and deploy the required set of autonomous machine cluster configurations with the associated models, policies, tasks, etc. from a library and integrate individual models onto the same deployment environment. It may be further desirable to select the set of the required set of autonomous machine cluster configurations with associated models, policies, tasks, etc. as required for that particular workflow from the library in response to instructions from a high level using methods such as template matching, rules, etc. It may further be desirable to address various issues related to the integration of AI/ML multiple models onto the same environment, such as duplication of functions across different AI/ML models, automatic transformations of robot actions in each model onto the single base coordinate systems, etc. Furthermore, it may also be desirable to enable synchronization and coordination of actions between different autonomous machines across clusters of autonomous machines.

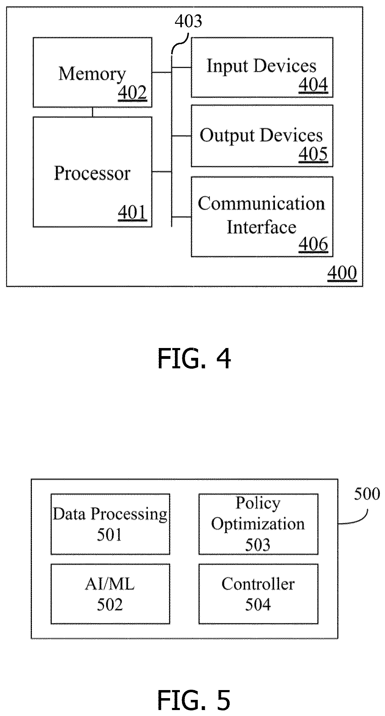

FIG. 4 shows an example of a device in accordance with various aspects of this disclosure. The device 400 includes a processor 401. The processor 401 may include a central processing unit, a graphics processing unit, a hardware acceleration unit, a neuromorphic chip, and/or a controller. The processor 401 may be implemented in one processing unit, e.g. a system on chip (SOC), or an integrated system or chip. The processor 401 may include one or more processors.

The device 400 may further include a memory to store data for related functions with respect to the device 400. In various examples, the processor 401 and memory 402 (and also other various components of the device) may be communicatively coupled over an internal interface 403 to communicate signals or data (e.g. a bus, wires, etc.).

The device 400 may include one or more input devices 404 that are configured to provide input to the device 400. The device may include a communication interface 406, and the interface 403 may be communicatively coupled to the input devices 404 via the communication interface 406. An input device 404 may store the environment information, and the processor 401 may access the environment information that is stored on the input device 404.

The device 400 may further include one or more output devices 405 to provide an output. Alternatively, or additionally, the interface 403 may be communicatively coupled to the output devices 405. The interface 403 may be coupled to the output devices 405 via the communication interface 406 as well. The interface 403 may be coupled to the output devices 405 electrically (e.g. via a wired or wireless connections) to provide an output. The communication interface 406 may also manage the communication between the device 400 and the output devices 405.

Accordingly, within various aspects of this disclosure, the device 400 may receive various information from the input devices 404 and transmit various information to the output devices 405. In various examples, the device 400 may include the corresponding input or output device, or the device 400 may be communicatively coupled to the corresponding input or output device over the communication interface 406.

Furthermore, another device may be both an input device and an output device for the device 400. For example, one of the input/output devices may include a display. The display may be configured to provide a visual output to a user or an operator. Furthermore, the display may include a touch screen display that is configured to receive an input from the user interacting with the display. The contact interaction from the user may be detected by a touch input unit. The touch input unit may be configured to detect the interaction of the user with the display via a contact of the user. The touch input unit may be configured to detect contact and/or movement of the user (e.g. via a finger, via a stylus, etc.,) while touching the display. Alternatively, the touch input unit may be configured to detect the interaction of the user via another defined surface. For example, the touch input 208 may include a touchpad that is configured to receive input from the user. Accordingly, the display may be both an example of an input device and an output device.

There may be various types on input and/or output devices 404, 405, such as hardware buttons and/or a keyboard, audio input/output devices such as a microphone and/or a loudspeaker, haptic devices, sensors such as image sensors (cameras), and/or accelerometers, and/or speedometers, and/or altimeters, and/or gyroscopes, and/or velocity sensors, and/or proximity sensors, and/or light sensors (e.g. ambient light sensor), and/or finger print sensors, and/or near field communication (NFC) sensors. These devices are provided only as examples. Furthermore, the input and output devices may also include autonomous machines and other components of the autonomous machines. With respect to various aspects of this disclosure, autonomous machines may provide information with respect to their detected environment by their acquisition devices. In various examples, autonomous machines may provide such information to the device 400 by sending unprocessed data or processed data with respect to their detection functions.

Furthermore, the device 400 may include a communication interface 406 (e.g. a communication circuit). The communication interface 406 may manage any type of communication with other devices (e.g. input devices 404 or output devices 405) for the device 400. The communication interface 406 may be communicatively coupled to the other devices (via wired or radio communication), and the communication interface 406 may provide the data received from the other devices to the interface 403. The communication interface 406 may receive the data over a communication network or via peer-to-peer communication (e.g. ad-hoc) from the other devices. Furthermore, the communication interface may transmit data to the other devices. The communication interface 406 may support any one or more of the communication protocols or communication technologies, some of which are exemplarily provided in this disclosure. In accordance with various aspects of this disclosure, the device 400 may be communicatively coupled to various devices (e.g. one or more communication devices 120) of autonomous machines over the communication interface 406 as input or output devices.

In various examples, the communication interface 406 may provide communication within the edge communication network (i.e. between other edge computing nodes, or edge computing devices). In various examples, an input or output device may be another computing device and/or a memory (e.g. data storage). There are various aspects provided with respect to processing data in this disclosure, and the device 400 may perform certain aspects by accessing data stored on an external device using the communication interface 406.

The processor 401 may access a plurality of operation policies associated with a plurality of autonomous machines. Each operation policy may provide a policy to operate one or more autonomous machines of a cluster of autonomous machines for a trained task. In various examples, an operation policy may include a policy of an AI/ML based task performance model for an autonomous machine. The policy may include a trained policy for one or more trained tasks. Each operation policy may provide one or more policies to operate one or more autonomous machines of the cluster of autonomous machines for the trained task based on or more policy parameters. In various examples, the operation policy may include a trained policy for each autonomous machine of the corresponding autonomous machine cluster. In various examples, more than one autonomous machine of the respective autonomous machine cluster may use the operation policy. In an example, all autonomous machines of the respective autonomous machine cluster may use the operation policy.

Furthermore, the processor 401 may receive information indicating an input task. The received information may include task data. The processor 401 may determine a layout for a plurality of autonomous machine clusters to be deployed in a predefined environment based on the plurality of operation policies associated for the plurality of autonomous machines and the input task. The determined layout may include information indicating how the plurality of autonomous machine clusters are to be deployed in the predefined environment, especially in terms of spatial and functional aspects. Accordingly, the determined layout may include spatial information, such as location, size, operation dimensions, etc. with respect to each of the autonomous machine clusters to be deployed, and functional information with respect to the interaction of the autonomous machine clusters.

Furthermore, each operation policy may include one or more trained policies based on a predetermined trained task, and the input task may be different than the trained task. In addition, the determined layout may include conditions in terms of spatial and/or functional aspects that may be different than the training conditions and the trained task. Accordingly, the processor 401 may adjust the one or more policy parameters of at least one of the plurality of operation policies according to the determined layout in the predefined environment and the input task. In various examples, the processor 401 may deploy the autonomous machine clusters (i.e. the autonomous machines of the autonomous machine clusters) based on the determined layout.

In various examples, the processor 401 may be communicatively coupled to a user interface (e.g. over an input/output device, such as a display), or the device 400 may include a user interface to receive the input task and select the plurality of operation policies based on the received input task from a set of operation policies. In various examples, the processor 401 may determine the layout using an AI/ML model. In various examples, the processor 401 may generate a plurality of candidate layouts and select one of the candidate layouts as the layout. In various examples, the processor 401 may adjust the one or more policy parameters further based on environment data with respect to the environment after the deployment and/or re-plan a new layout in an adaptive manner. In various examples, the processor 401 may further provide training to train previously trained tasks with respect to the input task.

FIG. 5 shows an example of a processor of a device (e.g. the device 400) according to various aspects provided in this disclosure. The processor 500 is depicted to include various functional modules that are configured to provide various functions respectively. The skilled person would recognize that the depicted functional modules are provided to explain various operations that the processor 500 may be configured to. The processor 500 may include a data processing module 501, an artificial intelligence / machine learning (AI/ML) module 502, a policy optimization module 503, and a controller 504.

The data processing module 501 may perform various types of processing as provided with respect to various aspects of this disclosure. The data processing module 501 may process environment data indicating one or more detected states of the environments based on their detections. The data processing module 501 may receive the environment data from another entity, or the data processing module 501 may access the environment data stored in a memory (e.g. the memory 402). In accordance with various aspects of this disclosure, the data processing module 501 may receive sensor data with respect to detection and/or monitoring activities of a plurality of sensors. The device may include or may be communicatively coupled to a plurality of sensors located at various places of the environment (i.e. the deployment environment) providing sensor data with respect to their local application environment.

The sensors may be any type of sensors that may help the device to obtain information with respect to various events in the environment. For example, the device may be communicatively coupled to a plurality of image sensors (e.g. cameras) located at various locations and positions in the environment. The data processing module 501 may accordingly receive sensor data from the sensors providing information with respect to location and movements of autonomous machines, workpieces, location and movements of humans in the environment, interactions between autonomous machines, interaction between autonomous machines and humans, etc. to obtain the environment data.

Furthermore, the device may also be communicatively coupled to the autonomous machines in the environment, which periodically, or in response to a request, provide information with respect to their detected environment using their sensors or other monitoring or detection devices. Accordingly, the data processing module 501 may receive sensor data from the autonomous machines in the environment providing information with respect to the environment of each autonomous machine with respect to the location and movement of the respective autonomous machines and its interaction with other autonomous machines, autonomous machine interaction with the workpieces especially with respect to their task performance, location and movements of humans in the environment and their interaction with the respective autonomous machine, etc. to obtain the environment data.

In various examples, there may further devices (e.g. other computing devices, edge computing devices, edge computing nodes) that may receive sensor data either from their sensors or sensors located in the environment, or other autonomous machines. The device may also be communicatively coupled to the further devices to receive information from them. Accordingly, the data processing module 501 may also receive sensor data from other computing devices in the environment to obtain the environment data.

In accordance with various aspects of this disclosure, the data processing module 501 may also receive with respect to communication activities in the environment. The autonomous machines may be configured to communicate with each other, or the device, or other computing devices in the environment, and the data processing module 501 may receive information with respect to the communication activities in the environment to obtain the environment data. In various examples, the autonomous machines may provide information indicating the communication activities, or failures in terms of communication to the device.

The data processing module 501 may obtain the environment data by combining the received information, some of which are exemplarily provided above. In various examples, the data processing module 501 may perform data fusion techniques (e.g. sensor fusion) to combine the sensor data received from different entities, and also the communication activities. The environment data may be in a time-series configuration providing information with respect to various detected and/or monitored attributes for a plurality of time.

Although the processor 500 may also employ the AI/ML module 502 to perform some of the functions provided here, the data processing module 501 may perform various types of predictions or determinations with respect to various aspects based on the environment data.

For example, the data processing module 501 may identify humans in the environment based on the environment data, and using the time-relation with respect to the time-series configuration of the environment data, the data processing module 501 may predict the movement of one or more humans in the environment based on the environment data. The data processing module 501 may predict an interaction between one or more humans and one or more autonomous machines in the environment based on the environment data. In various examples, the data processing module 501 may predict an interaction of a human with at least one of the autonomous machines in the environment based on the environment data. The predicted interaction may include an intersection of movement trajectories, an intersection of movement trajectories within a predefined period of time, coming within a predefined range of each other for a period of time, etc.

The data processing module 501 may further identify whether the environment includes a workspace for autonomous machines that is shared with humans, or of a section in the environment in which the trajectories of autonomous machines are predicted to go into workspaces of humans. Furthermore, the data processing module 501 may further identify a communication failure event between at least two ARMs in the environment based on the environment data. Furthermore, the data processing module 501 may identify locations with a reduced visibility based on the environment data, and/or detect visibility conditions under a predefined visibility metric based on the environment data.

The processor 500 may further include an AI/ML module 502. The AI/ML module 502 is depicted as it is implemented in the processor 500 only as an example, and any type of AI/ML implementations which may include the implementation of the AI/ML in an external processor, such as an accelerator, a graphics processing unit (GPU), a neuromorphic chip, or in another edge computing device or another cloud computing device, or in a memory (e.g. the memory 402) may also be possible according to any methods.

The AI/ML module 502 may implement various types of AI/ML as provided with respect to various aspects of this disclosure. In various examples, a controller (e.g. the controller 504) may control the AI/ML module 502. For example, the controller 504 may provide the input data to the AI/ML module 502, or provide the AI/ML module 502 instructions to perform an AI/ML. In various examples, the policy optimization module 503 may also control various operations of the AI/ML module 502.

The AI/ML module 502 may implement an AI/ML. The AI/ML may be any type of machine learning model configured to receive the input data and provide an output as provided in this disclosure. The AI/ML may include any type of machine learning model suitable for the purpose. The AI/ML may include a neural network, including various types of neural networks. The neural network may be a feed-forward neural network in which the information is transferred from lower layers of the neural network close to the input to higher layers of the neural network close to the output. Each layer includes neurons that receive input from a previous layer and provide an output to a next layer based on certain weight parameters adjusting the input information.

The AI/ML may include a convolutional neural network (CNN), which is an example for feed-forward neural networks that may be used for the purpose of this disclosure, in which one or more of the hidden layers of the neural network include a convolutional layer that performs convolutions for their received input from a lower layer. The CNNs may be helpful for pattern recognition and classification operations. The CNN may further include pooling layers, fully connected layers, and normalization layers.

In accordance with various aspects of this disclosure, the AI/ML may include a generative neural network. The generative neural network may process input data in order to generate new sets based on the training. In various examples, the AI/ML may include a generative adversarial network (GAN) model in which a discrimination function is included with the generation function, and while the generation function may generate the data according to model parameters of the generation function and the input data, the discrimination function may distinguish the data generated by the generation function in terms of data distribution according to model parameters of the discrimination function. In accordance with various aspects of this disclosure, a GAN may include a deconvolutional neural network for the generation function and a CNN for the discrimination function.

The AI/ML may include a recurrent neural network in which the neurons transfer the information in a configuration that the neurons may transfer the input information to a neuron of the same layer. Recurrent neural networks (RNNs) may help to identify patterns between a plurality of input sequences, and accordingly, RNNs may identify temporal pattern provided as a time-series data and perform predictions based on the identified temporal patterns. In various examples of RNNs, long short-term memory (LSTM) architecture may be implemented. The LSTM networks may be helpful to perform classifications, and processing, and predictions using time series data.

The AI/ML may include an LSTM network including a network of LSTM cells that may process the attributes provided for an instance of time from the input according to the attributes provided for the instance of time and one or more previous outputs of the LSTM that have taken in place in previous instances of time, and accordingly, obtain the output. The number of the one or more previous inputs may be defined by a window size. The window size may be arranged according to the processing, memory, and time constraints and the input data. The LSTM network may process the features of the received raw data and determine a label for an attribute for each instance of time according to the features.

In various examples, the neural network may be configured in top-down configuration in which a neuron of a layer provides output to a neuron of a lower layer, which may help to discriminate certain features of an input.

The AI/ML may include a reinforcement learning model. The reinforcement learning model may be modeled as a Markov decision process (MDP). The MDP may determine an action from an action set based on a previous observation which may be referred to as a state. In a next state, the MDP may determine a reward based on the next state and the previous state. The determined action may influence the probability of the MDP to move into the next state. Accordingly, the MDP may obtain a function that maps the current state to an action to be determined with the purpose of maximizing the rewards.

In one example, the reinforcement learning model may be based on Q-learning to extract the semantic information in the particular state according to a Q-function based on AI/ML parameters. The Q-function may be represented with an equation:

$$Q_{new}(s_t, a_t) \leftarrow (1-\alpha)\, Q(s_t, a_t) + \alpha\, (r + \gamma\, \max_a(Q(s_{t+1}, a)))$$

In the Q-function equation, s representing the state and a representing the action, indicating all state-action pairs with an index t, the new Q value of the corresponding state-action pair t is based on the old Q value for the state-action pair t and the sum of the reward r obtained by taking action at in the state st with a discount rate $\gamma$ that is between 0 and 1, in which the weight between the old Q value and the reward portion is determined by the learning rate $\alpha$. With respect to this illustrative example, the received raw data may indicate the state, and the actions may include classifying one or more attributes for the received raw data.

In accordance with various aspects of this disclosure, the AI/ML may include a multi-armed bandit reinforcement learning model. In multi-armed bandit reinforcement learning models, the model may test available actions at substantially equal frequencies. With each iteration, the AI/ML may adjust the machine learning model parameters to select actions that are leading better total returns with higher frequencies at the expense of the remaining selectable actions, resulting in a gradual decrease with respect to the selection frequency of the remaining selectable actions, and possibly replace the actions that are gradually decreased with other selectable actions. In various examples, the multi-armed bandit RL model may select the actions irrespective of the information representing the state. The multi-armed RL model may also be referred to as one-state RL, as it may be independent of the state. Accordingly, with respect to examples provided in this section, the AI/ML may include a multi-armed bandit reinforcement learning model configured to select actions without any information indicating the state.

The AI/ML may include a trained AI/ML that is configured to provide the output as provided in various examples in this disclosure based on the input data. The trained AI/ML may be obtained via an online and/or offline training. For the offline training, a training agent may train the AI/ML based on conditions of the device including the environment (e.g. deployment environment), capabilities of the autonomous machines, predefined tasks which the policies are trained for, etc. in a past instance of time. Furthermore, the training agent may train the AI/ML (e.g. by adjusting the machine learning model parameters stored in the memory) using online training methods based on the latest (or actual) implementation conditions. Furthermore, the processor 500 may further optimize the AI/ML based on previous inference results, and possibly based on a performance metric with respect to the previous inference results and the effects obtained in response to the previous inference results.

The training agent may train the AI/ML according to the desired outcome. The training agent may provide the training data to the AI/ML to train the AI/ML. The processor 500 may implement the training agent, or another entity that may be communicatively coupled to the processor 500 may include the training agent and provide the training data to the device, so that the processor 500 may train the AI/ML. In various examples, the device may include the AI/ML in a configuration that it is already trained (e.g. the machine model parameters in the memory are set). It may desirable for the AI/ML itself to have the training agent, or a portion of the training agent, in order to perform optimizations according to the output of the inferences to be performed as provided in this disclosure. The AI/ML may include an execution module and a training module that may implement the training agent as provided in this disclosure for other examples. In accordance with various examples, the training agent may train the execution module based on a simulated environment that is controlled by the training agent according to similar considerations and constraints of the deployment environment.

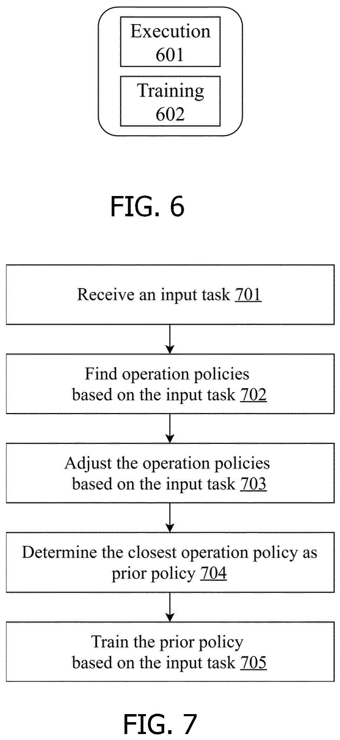

FIG. 6 shows an illustration of an exemplary AI/ML module. The AI/ML module may include an execution module 601 configured to receive the input and provide the output, and a training module 602 including the training agent as provided in this disclosure to provide necessary training for the AI/ML module by training the execution module 601 according to defined training conditions (e.g. training environment, training data, etc.). In an example, the training module 602 may further include a neural network to train the execution block 601.

The operation policies may include trained operation policies based on a predefined trained task at predefined training conditions. The predefined training conditions may include a training only based on a section of the environment (e.g. within a predefined section of the environment with dimensional constraints), a training with a predefined number of autonomous machines for a respective cluster, a training within a proximity of predefined autonomous machine clusters, a training within a predefined proximity of human workspaces, etc.

For example, each operation policy associated with each autonomous machine cluster may be trained within the section in a predefined section selected for training operation policy of the respective autonomous machine cluster independent from other autonomous machine clusters. The predefined section may be the same for all autonomous machine clusters (e.g. within the environment without further dimensional constraints, or within defined section of the environment). Each operation policy may also be associated policy information indicating various aspects with respect to the operation policy. A supervising agent (e.g. an operator, or a supervising algorithm) may generate at least a portion of the associated policy information.

Exemplarily, associated policy information may include trained tasks of the operation policy, task data with respect to the trained tasks, number of autonomous machines for the trained autonomous machine cluster (i.e. the number of autonomous machines that the autonomous machine cluster is trained for), autonomous machine types of the trained autonomous machine clusters, features of the autonomous machines in the trained autonomous machine clusters, properties of the workpiece that the autonomous machine cluster operates on (e.g. dimensions, weight, etc.), information related to the trained environment (e.g. dimensions, constraints, map of the environment, etc.), defined constraints between the plurality of autonomous machines, spatial information with respect to training location (e.g. a centroid and pose information) safety requirements for the respective autonomous machine clusters, at least some of the one or more policy parameters, etc.

For example, the training module 602 may train the operation policies of the autonomous machines of the respective autonomous machine clusters based on predefined parameters by the operator based on the exchange of information between the autonomous machines and the device. The training module 602 may receive information from autonomous machines (e.g. sensor data), feed the received information to the execution module 601, and optimize the operation policies based on the output of the execution module 601, and determine the action of the execution module based on the predefined AI/ML, when the execution module 601 may include an RL-based AI/ML. Furthermore, the processor may generate the associated policy information for the trained autonomous machine cluster.

The training module 602 may train a plurality of autonomous machine clusters for a plurality of predefined trained tasks for different conditions to obtain a plurality of operation policies with respect to a trained task, and as a result, obtain a plurality of operation policies for a plurality of autonomous machine clusters for various trained tasks at various training conditions. In various examples, the plurality of operation policies, and associated information with respect to each of the plurality of operation policies may be stored in the memory (e.g. the memory 402).

Referring back to FIG. 5, the data processing module 501 may further receive information indicating an input task. As provided before, the processor 500 may be communicatively coupled to an interface to receive information indicating the input task. The interface may include a graphical user interface, on which the operator may enter various information indicating the input task, which may further include at least one of a task indicator, a number of autonomous machines for each autonomous machine cluster, one or more autonomous machine types for each autonomous machine clusters, other autonomous machine cluster information, an input layout, an indication with respect to a deployment section (e.g. predefined coordinates, predefined dimensions), information indicating the workpiece(s), features of the autonomous machine clusters, information related to the environment, etc.

The data processing module 501 may access the operation policies stored in the memory, and select a plurality of operation policies from the operation policies based on the information indicating the input task (e.g. task data), in which each operation policy may be associated with at least one autonomous machine of an autonomous machine cluster. Based on the received information indicating the input task, the data processing module 501 may select the plurality of operation policies required for the particular workflow according to the input task using various methods including a template matching method, or a rule-based method based on the received information and the associated policy information with respect to the operation policies.

In various examples, the operator may also simply select the operation policies using a list defining the available operation policies, or any other type of selection functions may be performed in collaboration between the data processing module 501 and the corresponding user interface, such as providing only selectable options corresponding to the available operation policies in the memory, etc.

FIG. 7 shows an example of a flow diagram showing an on-the-fly policy learning that the data processing module 501 may implement. The data processing module may receive 701 information indicating the input task. In accordance with various aspects of this disclosure, the input task may include a plurality of tasks, or the data processing module may map the input task to a plurality of tasks in which an autonomous machine cluster may perform each of the tasks. Such one or more tasks that are to be associated with one autonomous machine cluster will be referred to as a task cluster in this disclosure. In various examples, the data processing module may map the input task to a plurality of task clusters based on stored information in the memory.

For example, the input task may include high-level information, and the data processing module may map the input task to a first task cluster including a conveyor belt pick and place task, a second task cluster including an assembly task, and a third task cluster including a storage task. With respect to this example, the input task may include information indicating a conveyor belt pick and place, an assembly task, and a storage task. Furthermore, the data processing module may receive or determine configuration parameters with respect to each of the task clusters (e.g. number of autonomous machines, dimension constraints to realize the task cluster (e.g. a layout defining a space to be occupied by the task cluster), autonomous machine types, features of the autonomous machines, one or more policy parameters, etc.), and a number of assigned tasks for each autonomous machine of the task cluster based on the information indicating the input task.

The data processing module may process the received information indicating the input task and check 702 if there are operation policies stored in the memory that the data processing module can match to the plurality of task clusters, in which an autonomous machine cluster may perform one or more assigned tasks. The data processing module may perform a template-matching or a rule-based approach by using the information indicating the input task, and the operation policies and associated policy information for each of the operation policies.

The data processing module may identify a task cluster that matches one of the operation policies stored in the memory, the data processing module may assign the matched operation policy for the task cluster. With respect to exemplary task clusters above, the data processing module may identify that the operation policies include an operation policy for the second task cluster, and assign the matched operation policy for the second task cluster.

The data processing module may assign a matching score based on the comparison between the configuration parameters with respect to each of the task clusters and each operation policy and associated information for the respective operation policy. Because operation policies may be trained independently for various trained tasks, the data processing module may not identify an operation policy with respect to a task cluster that provides an exact match. Accordingly, based on the comparison between the respective configuration parameters of a task cluster and each of the operation policies and associated information for the respective operation policy (e.g. comparing autonomous machine types, autonomous machine features, assigned tasks for each autonomous machine, etc.), the data processing module may determine one or more operation policies that have the respective matching score above a predefined matching score threshold (e.g. 70/100, 85/100) as candidate operation policies for the respective task clusters.

The data processing module may identify the candidate operation policies for the respective task cluster, the data processing module may determine to update one or more policy parameters with an intention to increase the matching score between the configuration parameters of the task cluster and respective operation policy. In various examples, the operation policy may include a reinforcement learning policy including a state-action space including a plurality of states, and a plurality of actions.

In this example, the one or more policy parameters may include various parameters with respect to state-action space. For example, the data processing module may recognize that a robotic arm needs to reach a further distance than what the respective operation policy is trained for based on the configuration parameters of the task cluster. For example, the data processing module may recognize that some of autonomous machines are inoperable condition with respect to the operation policy, and the number of autonomous machines is different than the input task, etc. The data processing module may perform adjustments 703 in the state-action space based on the configuration parameters of the task cluster.

The data processing policy may determine 704 an operation policy from the candidate operation policies that is closest to the configuration parameters (e.g. based on the matching score or an updated matching score after the adjustments), the data processing module may assign the determined operation policy as a prior model (e.g. as an RL prior), and provide information to the training module indicating the determined operation policy. The training module may train 705, or schedule the determined operation policy to be trained with the deployment, the determined operation policy by using the determined policy as a prior model by online training. The data processing module may analyze the state-action space of the operation policies and select the closest candidate operation policy according to the state-action space.

In accordance with various aspects of this disclosure, the data processing module may provide information to the training module indicating a training to be performed with respect to the respective task cluster. The data processing module may indicate to the training module that an offline training may be needed for the respective task cluster. For example, the data processing module may provide such indication in case the data processing module is not able to identify an operation policy that matches with the respective task cluster, or identify a matching score above the predefined threshold. For example, the respective task cluster may include a task of welding or screwing, however, operation policies stored in the memory may not include a trained operation policy for welding or screwing. Alternatively, autonomous machines of the respective task clusters may not be operable at that moment. It may be desirable to accommodate the clusters in a new environment with totally different constraints, etc. Accordingly, the training module may train an autonomous machine cluster with supervised training to obtain an operation policy for the respective task cluster according to the configuration parameters of the respective task cluster.

Accordingly, the data processing module may determine a plurality of operation policies based associated with the input task, in which each of the operation policies may provide a policy to operate one or more autonomous machines of an autonomous machine cluster assigned for a respective task cluster associated with the input task. The processor may determine the layout based on the obtained operation policies that are associated with the input task. The processor may use an AI/ML to determine the layout, which the AI/ML may receive input data and provide an output including at least one generated layout. The data processing module (or the controller) may provide the obtained operation policies with respect to associated task clusters to the input of an AI/ML to determine a layout with respect to the obtained operation policies for the associated task clusters.

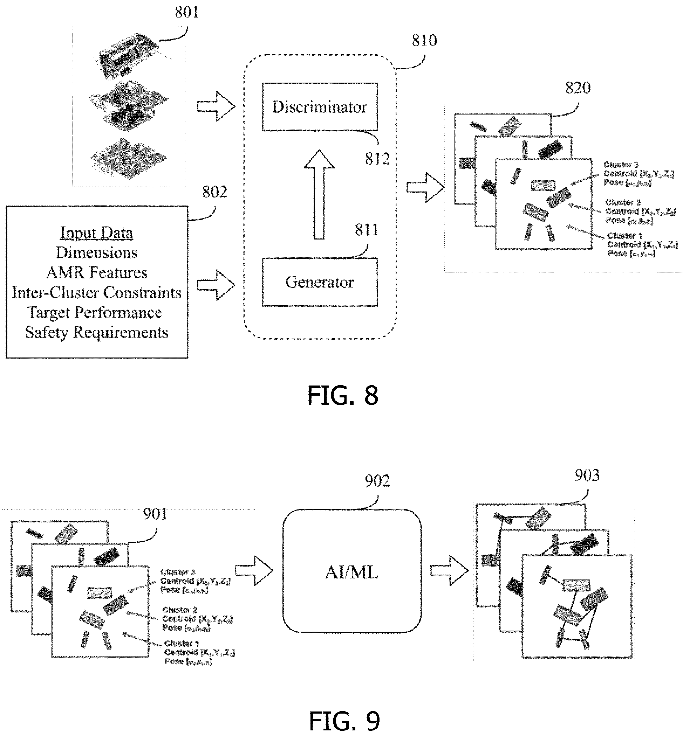

FIG. 8 shows an example of an AI/ML, which the AI/ML module 502 may implement. The AI/ML 810 may include a generative neural network. The generative neural network may include a generative adversarial network (GAN) including a discriminator 812 and a generator 811. The AI/ML 810 may be configured to generate a plurality of layouts based on the input. The AI/ML 810 may include a trained GAN. The AI/ML 810 may receive an input including a graphical representation 801 (e.g. an image, a map, a layout, etc.) of the environment (i.e. the deployment environment, which is depicted as a factory image in the figure), and input data that may further include dimensions of the environment. The input data may further include information from associated policy information 802 of each determined operation policy including at least one of the features of the plurality of automated machine clusters (e.g. an allocation dimension for the autonomous machine cluster, autonomous machine types, autonomous machine capabilities), constraints between the plurality of autonomous machine clusters, a target performance metric for the respective autonomous machine cluster, safety requirements of the plurality of autonomous machine clusters.

In this illustrative example, the generator 811 may receive the input data. The generator 811 may generate plausible layouts based on machine learning model parameters for the generator 811 of the AI/ML 810. The generator 811 may provide the generated plausible layouts to the discriminator 812 that is configured to classify the generated plausible layouts as a layout to output or a layout to discard based on machine learning parameters for the discriminator 812 of the AI/ML 810. The discriminator 812 may further use the image of the environment for the classification. Based on the classification that the discriminator 812 determines in response to a received generated plausible layout, the discriminator 812 may optimize the machine learning parameters for the discriminator 812 of the AI/ML 810. Furthermore, the generator 811 may also optimize the machine learning parameters for the generator 811 based on the determination of the discriminator 812.

Accordingly, the generator 811 and the discriminator 812 optimize their respective machine learning model parameters, and the goal of the generator 811 is to generate a layout that the discriminator may determine as a layout to output from the AI/ML 810. The AI/ML 810 may be configured to output a plurality of generated layouts 820. The output of the AI/ML 810 may further include at least one of the spatial information of the location of autonomous machines (e.g. a centroid, or a pose) for each of the autonomous machine clusters with respect to the obtained operation policies. The output of the AI/ML 810 may include a plurality of vectors, or a matrix, or a plurality of matrices representing generated layout. The generated layout may include information indicating locations and/or dimensions of each of the autonomous machine clusters assigned for (as) the respective task cluster according to the respective operation policy.

FIG. 9 shows an example of an AI/ML, which the AI/ML module 502 may implement. The AI/ML 902 may include a graph neural network configured to provide an output 903 including information indicating relationships between autonomous machine clusters, based on an input 901 including a graphical information of a generated layout with respect to a plurality of autonomous machine clusters. The graphical information of the generated layout may include the plurality of generated layouts that another AI/ML (e.g. the AI/ML 810) may provide. The graphical information may include a representation of the generated layout indicating various features of the autonomous machine clusters within the generated layout. The graphical information may include a plurality of vectors or a matrix or a plurality of matrices representing the generated layout, and indicating locations and/or dimensions of each of the autonomous machine cluster assigned for the respective task cluster according to the respective operation policy.

The output 903 of the AI/ML 902 may include information indicating relations and relationships between autonomous machine clusters within the generated layout. In an example, the output 903 may include an adjacency matrix indicating the adjacent autonomous machine clusters. The processor may accordingly estimate interactions between the plurality of autonomous machine clusters for the generated layout. The AI/ML module 502 may input each generated layout (e.g. each output of the AI/ML 810) to the AI/ML 902, and obtain information indicating the relationships between the autonomous machine clusters for each generated layout. In various examples, the interactions may further include information indicating workflows including one or more assigned tasks for the respective task cluster of the autonomous machine cluster.

Referring back to FIG. 5, the data processing module 501 may receive the output 903 indicating the relationships between autonomous machine clusters within the generated layout and estimate a performance index with respect to each output. In other words, the data processing module 501 may receive a plurality of generated layouts including information indicating the relationship between autonomous machine clusters within each of the generated layouts, and estimate a performance index for each of the generated layouts based on the indicated relationship between autonomous machine clusters.

The data processing module 501 may estimate the performance index based on a predefined performance function of P.I.$=w_1 x_1 + w_2 x_2 + ... + w_n x_n$, in which $w_i$ includes a predefined weight parameter with respect to a parameter of the predefined performance function, and the $x_i$ includes the corresponding task parameter. The task parameters may include an inter-cluster distance parameter representing a distance between two autonomous machine clusters for each autonomous machine cluster, and/or a path length parameter representing the total length of paths of the autonomous machines configured to transport a workpiece for each autonomous machine cluster, a sequence for each autonomous machine cluster, a weight parameter representing a weight for workpiece(s) for each autonomous machine clusters, a speed of a conveyor belt transporting the workpiece, robotic manipulation parameters, a period of time defining duration of a task for each autonomous machine cluster, an order of tasks for each autonomous machine clusters, or deadlines for tasks for each autonomous machine clusters. The data processing module 501 may calculate the performance function for each autonomous machine cluster within a generated layout and sum the calculated amount for all autonomous machine clusters within the generated layout to obtain the performance index for the generated layout.

In various aspects, the data processing module 501 may access associated policy information and perform calculations based on the generated layout to obtain the task parameters for the predefined performance function. For this purpose, the data processing module 501 may evaluate the generated layout and indicated relationships between autonomous machine clusters, and perform adjustments with respect to spatial arrangements associated with the generated layout. In various aspects, a supervisor (e.g. an operator, or a user) may manually enter required information, and the data processing module 501 may calculate the performance index with respect to the predefined performance function based on the entered information with respect to the task parameters for each generated layout.

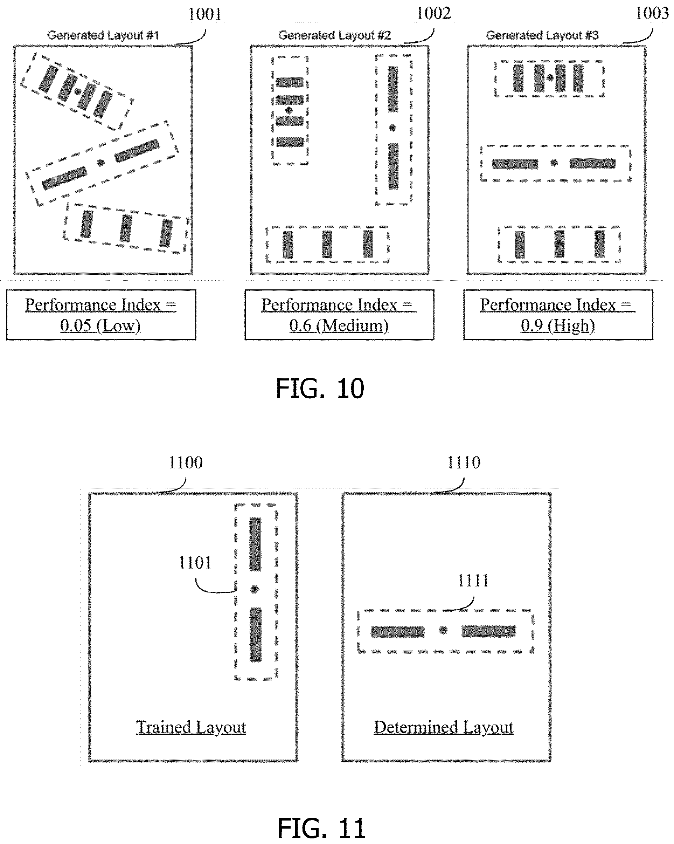

FIG. 10 exemplarily shows an illustration with respect to three generated layouts. Based on the calculated and normalized performance indexes by the data processing module, a first generated layout 1001 may result in a low performance index, a second generated layout 1002 may result in a medium performance index, and a third generated layout 1003 may result in a high performance index. As a result, the data processing module 501 may determine one or more layouts to proceed with the policy optimization as provided in this disclosure. The following examples are provided in a manner that the data processing module 501 has determined one of the generated layouts as the determined layout. The data processing module 501 may determine one of the generated layouts as the determined layout based on estimated routes for the autonomous machines, estimated routes for the autonomous machines estimated to transport material or workpiece, or work sequences of autonomous machines.

Referring back to FIG. 5, the processor 500 may further include the policy optimization module 503. The policy optimization module 503 may optimize the operation policies associated with a plurality of autonomous machine clusters with respect to the determined layout. For this purpose, the policy optimization module 503 may receive the plurality of operation policies (operation policies and associated policy information) associated with the plurality of autonomous machine clusters of the generated layout, and the information with respect to the generated layout (e.g. the generated layout and the relationships between autonomous machine clusters). The policy optimization module 503 may include various methods to optimize the operation policies, and at least for some of the policy optimization module 503 may cooperatively operate with the AI/ML module 502, in particular, the training module of the AI/ML module 502 to train the operation policies.

The policy optimization module 503 may use any known policy optimization methods to optimize the policy based on designated needs. Policy optimization methods may include various methods to numerically optimize the operation policies in various ways involving adjusting various parameters that the policy is based on. Especially, within the limits of reinforcement learning operation policies, each operation policy may map the observed state to a distribution of a set of actions, from which the agent selects the next action. One of the known methods to optimize the operation policies may include adjusting rewards.

The policy optimization module 503 may use derivative-free optimization (DFO) algorithms to optimize a policy. A DFO algorithm may operate by adjusting policy parameters in various ways and measuring the performance according to adjusted policy parameters. Some DFO algorithms may employ other types of optimization including crossentropy methods, covariance matrix adaptation, natural evolution strategies, HyperNEAT, etc.

Furthermore, the policy optimization module 503 may use policy gradient methods. Policy gradient methods, in general, rely on estimating a policy improvement direction by using various quantities that were measured by the respective agent of the operation policy. Furthermore, the policy optimization module 503 may use approximate dynamic programming (ADP). In an ADP, the policy optimization module 503 may rely on learning value functions that may use for predicting how much reward the respective agent of the operation policy is going to receive. In various aspects, the policy optimization module may also use a combination of various methods by approximating functions in various ways.

In accordance with various aspects provided in this disclosure, the determined operation policy for each autonomous machine cluster may include a reinforcement learning policy. The reinforcement learning policy may include various parameters to provide a mapping between an observation state and an action to be taken based on the observation state as policy parameters. The reinforcement learning policy may include a set of states (i.e. observation states) and a set of actions that are predefined. When a respective autonomous machine performs the task performance according to the reinforcement learning policy (RL policy), the respective autonomous machine may select an action from the set of actions based on a defined mapping between the set of states and the set of actions, based on an observation state that the autonomous machine has perceived using the sensor data, or other types of data providing an indication for the state of the autonomous machine based on the trained RL policy. In various examples, the autonomous machine may also consider a reward parameter based on previous actions. The state-action space and the reward parameters are provided as one or more policy parameters of the RL policy only for exemplarily purposes. The one or more policy parameters may further include a parameter with respect to a state or an action (e.g. coordinates, locations, a value, etc.), or any other aspects that may relate to the RL policy, in which the change of such parameter may affect the operation of the RL policy.

Accordingly, the RL policy may include various policy parameters including states from the set of states, action from the set of actions. Each RL policy with respect to each autonomous machine cluster may include different types of states and actions. For example, a mobile autonomous machine including a gripper may include a plurality of states associated with the mobility of the autonomous machine (e.g. location of the autonomous machine, velocity of the autonomous machine, heading of the autonomous machine, etc.), the gripper (the location of the gripper, the orientation of the gripper, force applied by the gripper, etc.), and actions associated with the states, while an autonomous machine for assembly purposes may include other types of information defined as states and actions to be associated with the states based on the corresponding trained RL policies (i.e. trained task). Furthermore, the reward may also include different reward functions and/or goals based on the trained task associated with the trained operation policy.

In accordance with various aspects of this disclosure, operation policies for autonomous machine clusters may include an operation policy trained for a training task, in which the respective autonomous machine cluster is trained according to different environmental conditions. It may be desirable to adjust one or more policy parameters of the RL policy of the respective autonomous machine cluster based on the determined layout. The policy optimization module 503 may adjust one or more policy parameters of the RL policy for at least one of the autonomous machine clusters of the plurality of autonomous machine clusters in the determined layout with an intention to transform the one or more policy parameters from the training environment which the respective autonomous machine cluster is trained and obtained the RL policy to the environment that the autonomous machine cluster is to be deployed based on the determined layout. It may be further desirable to further adjust the one or more policy parameters of the at least one of the autonomous machine clusters of the plurality of autonomous machine clusters in the determined layout with an intention to provide inter-cluster collaboration between autonomous machine clusters of the determined layout.

FIG. 11 shows an example illustration with respect to a trained layout and a determined layout for an autonomous machine cluster. In this illustrative example, the training agent according to various aspects of this disclosure may train an autonomous machine cluster 1101 in a training environment 1100 to obtain the trained RL policy(-ies) for the autonomous machines with respect to the autonomous machine cluster 1101. Accordingly, the trained RL policies for the autonomous machines with respect to the autonomous machine cluster may include various aspects based on the location of the autonomous machine cluster 1101 in the training environment, such as the kinematic information including the initial locations of the autonomous machines, the target location of the autonomous machines, goals, the coordinates that the autonomous machine interacts with the workpieces, coordinates of other objects that are in the environment, the coordinates which the autonomous machines may submit the workpiece for another cluster to operate, etc.

Once the location of the autonomous machine cluster to operate on changes, such as in the environment according to the determined layout 1110, in which the position and the pose of the autonomous machine cluster 1111 has changed (and there may be further changes in terms of allocated areas, etc. according to the generated layout), it may be desirable to adjust the policy parameters of the trained RL policy as indicated above. Such adjustment of policy parameters may include coordination transformations with respect to the coordinates in the set of states or the set of actions, rewards based on various actions including coordinates, etc. These adjustments are provided only for exemplary purposes.

Referring back to FIG. 5, the policy optimization module 503 may adjust the one or more policy parameters of the RL policy based on previously determined optimization function. For example, with respect to the coordination transformation, the policy optimization module 503 may access the spatial information with respect to the training location for the respective RL policy from the associated policy information, and the policy optimization module 503 may transform one or more policy parameters of the RL policy including coordinates based on the spatial information with respect to the training location of the autonomous machine cluster, and the spatial information with respect to the location of the autonomous machine cluster according to the determined layout.

In various examples, the policy optimization module 503 may abstract assembly parameters from the environment according to the determined layout and generate observations for each of the RL policies of each autonomous machine cluster. The policy optimization module 503 may provide the generated observations to the AI/ML module 502, and the training module of the AI/ML module 502 may train the respective RL policy based on the generated observations to obtain new actions. It may be further desirable for the policy optimization module 503 to set up the assembly, spawn and arrange objects (e.g. workpieces or other objects) at the desired locations, and provide access to various assembly-specific parameters for each of the autonomous machine clusters in the environment. The training agent may then collate all the actions for each autonomous machine cluster and transform them into various attributes with respect to one or more policy parameters of the RL policy, such as the robot-like position control, gripper control, and rotation control of the gripper. In various examples, the processor 500 may run simulations to verify the adjustments. In this example, the policy optimization module 503 may act as a regulator and controller of the data flow through and from the simulation by providing generalized functions beyond the features of the environment that enable various tasks and the autonomous machine clusters according to the determined layout.

For this purpose, the policy optimization module 503 may adjust single robot identifiers, robot identifiers of the respective autonomous machine cluster, object identifiers, single robot goals, goals of the respective autonomous machine cluster, goal thresholds, delays, manual primitive values, action spaces, observation spaces, environmental initial states, maximum episode steps for the respective RL policy.

In accordance with various aspects of this disclosure, the policy optimization module 503 may optimize the RL policy by using an AI/ML. For this purpose, the policy optimization module 503 may obtain input data in order to provide the input data to the AI/ML module 502 so that the AI/ML module 502 may run the corresponding AI/ML to obtain at least one or more intermediate policy parameters with respect to the trained RL policy. The input data may include at least one of the dimensions of the environment, features of the respective autonomous machine cluster, a target performance metric for the respective autonomous machine cluster, safety requirements of the respective autonomous machine cluster, constraints between the respective autonomous machine cluster and other autonomous machine clusters in the determined layout, a representation of the determined layout, assigned tasks for the respective autonomous machine cluster, the RL policy of the autonomous machine cluster, or the adjacency matrix with respect to the determined layout. The policy optimization module 503 may provide similar input data for each of the autonomous machine clusters in the determined layout and provide them to the AI/ML module 502.

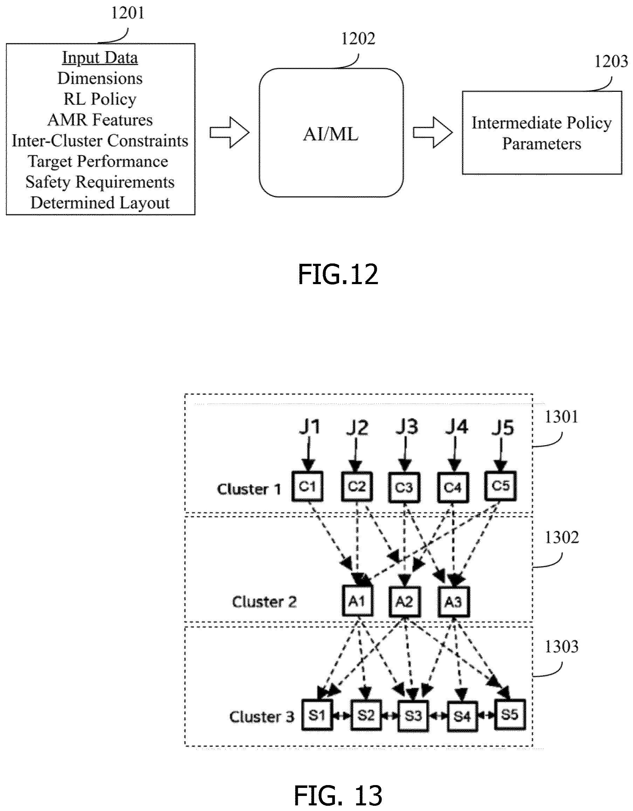

FIG. 12 shows an example of an AI/ML, which the AI/ML module 502 may implement. The AI/ML 1202 may be configured to provide a functional mapping of an input autonomous machine cluster to the environment according to the determined layout based on an input. The AI/ML 1202 may provide an output 1203 indicating one or more intermediate policy parameters with respect to the RL policy of the respective autonomous machine cluster. The AI/ML 1202 may receive the input data 1201 that may include the RL policy of the respective autonomous machine cluster and at least one of the dimensions of the environment, features of the respective autonomous machine cluster, a target performance metric for the respective autonomous machine cluster, safety requirements of the respective autonomous machine cluster, constraints between the respective autonomous machine cluster and other autonomous machine clusters in the determined layout, a representation of the determined layout, assigned tasks for the respective autonomous machine cluster, or the adjacency matrix with respect to the determined layout. The AI/ML 1202 may include a deeplearning model to provide the functional mapping that is trained to provide the output 1203.

Accordingly, the policy optimization module 503 may receive the information indicating one or more intermediate policy parameters with respect to an RL policy of an autonomous machine cluster according to the determined layout (i.e. output of the AI/ML 1202) and adjust the corresponding policy parameters of the RL policy of the respective autonomous machine cluster to the one or more intermediate policy parameters accordingly. The policy optimization module 503 may accordingly adjust each RL policy of each autonomous machine cluster in the determined layout in a similar manner. In accordance with various aspects, the policy optimization module 503 may keep the old RL policy and generate a new RL policy using the old RL policy and the one or more intermediate policy parameters, and use the new RL policy for the remaining operations.

Furthermore, the AI/ML module 502 may further train each RL policy of each autonomous machine cluster in the determined layout with an intention to increase the coordination between autonomous machine clusters according to the determined layout. The training agent may perform an online training to increase the coordination between autonomous machine clusters according to the determined layout. The training agent may train the RL policies based on any known RL training technique that may increase the coordination between the autonomous machine clusters.

In one example, the training agent may train each RL policy independently. In a reinforcement learning model, an agent may perceive a first state of the environment and take an action according to the perceived state at each instance of time. The taken action may transit the state of the environment to a second state at a later instance of time. The agent may further receive a reward with respect to the transition of the state and may have a goal to maximize the cumulative reward along with the operation of the RL policy. The training agent may train each RL policy using supervised training, in which the supervisor may enter supervising inputs in order to increase the coordination between the autonomous machine cluster according to the input task.

One of the aspects that inter-cluster coordination may target is scheduling between each autonomous machine cluster, and also between groups of autonomous machines working cooperatively in autonomous machine clusters (i.e. inter-cluster group). For example, a task for an autonomous machine of an autonomous machine cluster may include bringing the workpiece to a designated point so that another autonomous machine of another autonomous machine cluster may take the workpiece to perform its task. In other words, an output of a task of an autonomous machine of a first autonomous machine cluster may be an input of a task of another autonomous machine of a second autonomous machine cluster.

In various examples, the training agent may train the RL policies of the autonomous machine clusters for the determined layout according to a job-shop scheduling training. In various examples, the training agent may use a simpler but denser reward function, especially with respect to the inter-cluster groups of autonomous machines working cooperatively in autonomous machine clusters as exemplarily provided above.

FIG. 13 shows an illustration including a plurality of autonomous machines. According to a determined layout with respect to various aspects of this disclosure based on the input task, the determined layout includes a first autonomous machine cluster 1301, a second autonomous machine cluster 1302, and a third autonomous machine cluster 1302. The first autonomous machine cluster 1301 may include a plurality of autonomous machines C1, C2, C3, C4, C5, the second autonomous machine cluster 1301 may include a plurality of autonomous machines A1, A2, A3, and the third autonomous machine cluster 1303 may include a plurality of autonomous machines S1, S2, S3, S4, S5.

Each arrow of the drawing depicts a relationship with respect to tasks of the respective autonomous machines in terms of input and output. For example, a first autonomous machine C1 of the first autonomous machine cluster 1301 may perform a task in response to a received input task J1, and the output of the first autonomous machine C1 of the first autonomous machine cluster 1301 may be an input for a task of a first autonomous machine A1 of the second autonomous machine cluster 1302. In various aspects, one of the tasks based on the received input task J1 of the first autonomous machine C1 of the first autonomous machine cluster 1301 may include bringing a workpiece to the first autonomous machine A1 of the second autonomous machine cluster 1302. In a similar manner, one of the tasks of the first autonomous machine A1 of the second autonomous machine cluster 1302 may include taking the workpiece from the first autonomous machine C1 of the first autonomous machine cluster 1301.

With respect to this illustrative example, the training agent may train the first autonomous machine C1 of the first autonomous machine cluster 1301 and the first autonomous machine A1 of the second autonomous machine cluster 1302, as they form an inter-cluster group as provided above. In various aspects, the training agent may train each group of autonomous machines, which the inter-cluster group of autonomous machines may refer to as a plurality of autonomous machines having a task-relationship in between, in which output with respect to a task of an autonomous machine may include input with respect to a task of another autonomous machine in the inter-cluster group.

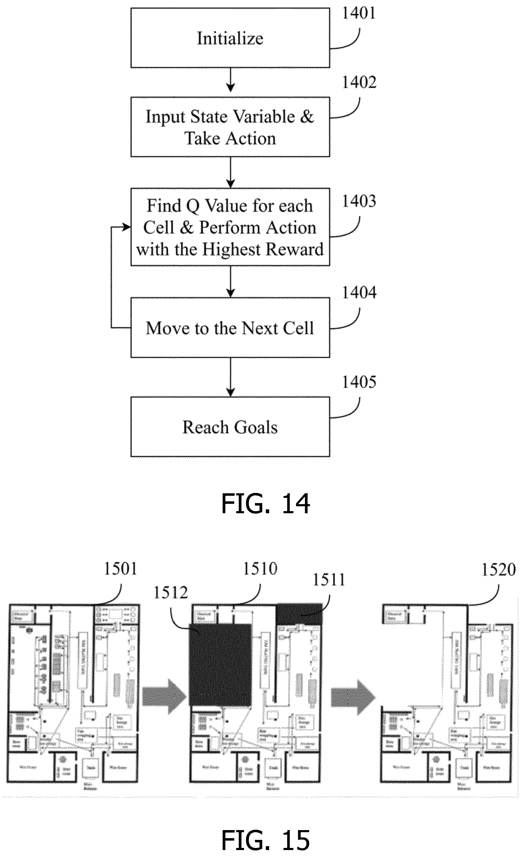

FIG. 14 exemplarily shows a training flow diagram, that the training agent may perform. As indicated before, the respective AI/ML module (e.g. AI/ML module 502) may include a traing module (e.g. the training module 602) to implement the training agent. The training agent may initialize 1401 the environment and various parameters of the respective RL policy. The training agent may define a state space indicating the location of autonomous machines, beginning positions and end positions of the autonomous machines, status of each cluster (especially the cluster in the beginning and the cluster at the end) which may include an indication of whether the respective cluster is occupied or available, state of autonomous machines which may include an indication whether the respective autonomous machine is carrying a workpiece or not carrying a workpiece, vector of positions for all other autonomous machines.

Once the training agent has performed the initialization, the training agent may provide 1402 an input state for the respective RL policy of the respective autonomous machine, in which the respective AI/ML (i.e. the execution module) takes an action based on the input state with the respective RL policy. Based on the taken action, the respective AI/ML may update 1703 Q value for the respective state-action pair and perform an action with the highest reward. The training may include repeating 1704 updates of the Q-value for each of the state-action pairs and choosing the action with the highest reward until the defined goal is reached 1705.

In accordance with various aspects for training the respective RL policies, the state at each instance of time may be based on state information according to the determined layout. The state information may include a location of the one or more automated machines of the plurality of automated machine clusters, a beginning and a final positions for each automated machine of the plurality of automated machine clusters, a status of each automated machine for the plurality of automated machine clusters indicating whether the respective automated machine is loaded or unloaded, a status of each automated machine clusters indicating whether the respective automated machine cluster is occupied or available, vector positions of the each automated machines of the plurality of automated machine clusters.

Once the training agent has trained the respective RL policies according to the determined layout, the one or more policy parameters of the respective RL policy are to be adjusted (whether from the original one or more policy parameters or from intermediate one or more policy parameters according to the selection) to obtain the one or more final policy parameters of the respective RL policy, which will be referred to as final operation policy in this disclosure referring to an adjusted version of the operating policies stored in the memory. The device according to various aspects of this disclosure may deploy the autonomous machines according to their final operation policies.

For this purpose, the respective RL policy may include a reward structure based on various parameters including the distance between the respective autonomous machine and a final goal, a detected collision, etc. For example, the reward function of the respective RL policy may provide a high reward (e.g. 100) in case the distance between the autonomous machine and the defined final goal is reduced at the next state if the autonomous machine is loaded. If the autonomous machine is unloaded, the reward function may assign a low reward (e.g. -100, which may also be referred to as a penalty) in the same situation. Furthermore, in case the distance between the autonomous machine and the defined final goal increases, the reward function may determine a low reward.

In case collusion with another object (e.g. another autonomous machine or another object in the environment) is detected at a respective state, the reward function may determine a very low reward (e.g. -500). In case, the defined final goal is reached, the reward function may determine a very high reward (e.g. 1000). Furthermore, when the goal is reached, the training agent may swap the predefined beginning state and the ending state. For an example of providing training for an autonomous machine that is tasked to move from one cluster to another cluster, the set of actions may include moving left, right, forwards, backward, or a goal reached.

The training agent may perform a multi-agent reinforcement learning model to train the RL policies of the autonomous machine clusters. In a multi-agent reinforcement learning model, the training agent may train each RL policy using multiple agents (i.e. an agent for each RL policy). When an agent of an RL policy of an autonomous machine cluster evaluates a state and receives a reward, joint actions of other agents of other RL policies may influence the corresponding state and the reward for the agent. Because each agent may be configured to optimize its own rewards according to its own RL policy, such optimization may also become a function of other RL policies.

Referring back to FIG. 5, the policy optimization module 503 may further calculate a performance metric for End to End application of the operating policies according to the determined layout according to any known methods. The performance metric may include various parameters as a performance indicator including, time to complete the input task, time for each autonomous machine cluster to perform their respective tasks, idle time of autonomous machines in each autonomous machine cluster, etc.

The processor may further include a controller 504 to control various operations of the device 500. The controller 504 may coordinate, sequence and time synchronize different autonomous machine clusters in the environment according to the determined layout. The controller 504 may further allocate timing constraints (start-stop times, global time synchronization, etc.) and monitor the operation according to the various aspects of this disclosure. Furthermore, the controller 504 may interface with simulator models and gather all the required state information of the system and monitor the behavior of the system. Also, the controller 504 may provide the physical layout information as well as the control signals that are generated from the RL policy using the observations. In an example, the controller 504 may include a state estimation machine to perform estimations with respect to the states.

The controller 504 may further provide instructions to deploy the autonomous machines within their respective autonomous machine clusters according to the determined layout, in which the autonomous machines may operate based on their final operation policies. There are various methods to deploy autonomous machines with defined operation policies, and the disclosure will not provide details for this aspect, but the corresponding system including the device and the autonomous machines may have different configurations for the deployment. One of the configurations may include each autonomous machine receiving its respective operation policy and providing task performance based on an AI/ML module that the respective autonomous machine implements. In this configuration, a controlling entity (e.g. device 500) may send the respective operation policies to the respective autonomous machines directly or through another entity. Alternatively, each autonomous machine may access an external memory (e.g. which the device 400 may implement) and obtain the respective operation policy from a designated memory location. Alternatively, the external memory may be on another device (e.g. another edge computing device, in the cloud, etc.), and the controlling entity (e.g. the device 400) may provide the respective operation policies to another device, so that each autonomous machine may access to the respective operation policies. Another configuration may include that a controlling entity (e.g. the device 400, or another device) may control each autonomous machine in the environment by sending control instructions according to the task performance model based on the respective operation policy of the respective autonomous machine.

In accordance with various aspects of this disclosure, the controller 504 may provide the necessary instructions using a communication interface to deploy the autonomous machines based on their final operation policies to a necessary entity, in which the necessary entity may include an external memory, autonomous machines, another controlling entity, etc. In various examples, the controller 504 may also provide the final operation policies of each of the autonomous machines according to the determined layout to a necessary entity in a similar manner.

Furthermore, the controller 504 may monitor the environment after the deployment in order to oversee the deployment according to the determined layout using the environment data that the data processing module 501 may obtain. The controller 504 may further identify various scenarios based on the deployment according to the determined layout, and in various cases, the controller 504 may provide instructions to other blocks of the processor 500 to adjust or re-plan the deployment.

For example, the controller 504 may predict the movements of humans based on the environment data and perform various actions based on the predicted movements of humans. The controller 504 may predict the movements of every mobile entity in the environment based on the environment data. The mobile entities may include any entity that the controller 504 detects an indication of a movement according to the environment data. The mobile entities may include humans, other vulnerable users (e.g. animals, pets), authorized autonomous machines to operate in the environment based on the input task, any other autonomous machines or machines in the environment, etc.

The controller 504 may predict a trajectory for each mobile entity in the environment and perform a risk assessment in terms of any type of unwanted interactions including collusion. The controller 504 may employ any known trajectory prediction methods including using AI/ML models to predict the trajectories or predict any risk of collusion. Furthermore, the controller 504 may further determine to send instructions to stop a designated autonomous machine based on the predicted movements according to the environment data. The controller 504 may determine to transmit the instructions to stop the designated autonomous machine, in case the predicted trajectory of the designated autonomous machine is within a predefined proximity of the predicted trajectory of another entity (e.g. human). If the trajectories are further than the predefined proximity, the controller 504 may not send any instruction.

In various examples, the controller 504 may determine to send instructions to reduce the speed of a designated autonomous machine based on the predicted movements according to the environment data. Especially, in case the controller 504 further anticipates that a deliberate interaction is intended by a human to the autonomous machine, the controller 504 may determine to send instructions to reduce the speed according to predefined safety criteria. The controller 504 may further other types of detection to reduce the risks of false detection of an anticipated interaction. For this purpose, the controller 504 may further check the environment data for other types of detections with respect to the respective human. In case the environment data includes information with respect to the biological measurements related to the respective human, and in case the biological measurements indicate that the respective human may be under stress (e.g. fast breathing, increased heart rate, etc.), the controller 504 may determine to send instructions to stop the designated autonomous machine.

Furthermore, the controller 504 may identify communication challenges with respect to each of the autonomous machines according to the environment data. An autonomous machine may have indicated failure of communication with other autonomous machines or other devices of the system. In various examples, the controller 504 may control the communication interface to measure the power of a communication signal received by an autonomous machine, and the controller 504 may determine a communication challenge based on the measurement (e.g. the measured signal strength is below 20dB). Based on an identification of a communication challenge, the controller 504 may determine to send instructions to stop the respective autonomous machine.

Furthermore, the controller 504 may identify visibility challenges with respect to each of the autonomous machines according to the environment data. An autonomous machine may enter into a section in which the visibility of the autonomous machine may be limited by conditions of the sections, blocked by other objects (human, workpieces, other autonomous machines, other machines, etc.). In various examples, the autonomous machine may have indicated the reduced visibility based on its sensor data. In various examples, the controller 504 may determine that the respective autonomous machine is not able to detect its environment based on the environment data by comparing the received information from the respective autonomous machine, and received information from other information sources for the environment data. The controller 504 may determine to send instructions to stop the respective autonomous machine based on the identification of visibility challenges.

In accordance with various aspects of this disclosure, the controller 504 may determine to transmit the corresponding instructions directly to the designated autonomous machine or another entity that is configured to control the designated autonomous machine, especially that may stop, slow down, or in any way control the designated autonomous machine. The controller 504 may encode information indicating the instruction, and control a communication interface (e.g. the communication interface 406) to transmit the information to its designated receiver.

Furthermore, the controller 504 may store information indicating detections with respect to the safety measures in a memory (e.g. the memory 402). Based on the stored information, the controller 504 may further determine to optimize operation policies of one or more autonomous machines in the environment. Accordingly, the controller 504 may provide instructions to the policy optimization module 503 to optimize the respective operation policies based on the stored information. In various examples, the policy optimization module 503 may modify the reward function of the respective operation policies in response to the instructions that the controller 504 provides.

For example, the controller 504 may determine to optimize operation policies of one or more autonomous machines based on the rate of detected safety events with respect to the one or more autonomous machines indicating a safety risk. The controller 504 may determine to optimize operation policies of one or more autonomous machines based on a number of detected safety events indicating a safety risk. The controller 504 may determine to optimize operation policies of one or more autonomous machines based on a risk parameter indicating the degree of the risk that the controller 504 may have determined.

Furthermore, the controller 504 may determine to re-plan the entire layout based on the stored information. For this purpose, the controller 504 may identify one or more sections in the environment based on the detection with respect to the safety measures. The controller 504 may provide instructions to determine a new layout without the identified sections for the input task.

FIG. 15 shows an exemplary illustration for a re-plan decision to determine a new layout for the input task. The device may have determined a layout for a deployment environment 1501 based on a floorplan. Accordingly, the device may have deployed autonomous machines according to the determined layout. After the deployment, the device may have identified safety-critical events in the deployed environment 1501 with a relatively high rate according to predefined security risks at a first section 1511 and a second section 1512. The device may determine to re-plan the deployment for an environment without the first section 1511 and the second section 1512. Accordingly, the device may use a new deployment environment 1520 to determine a new layout for the new deployment environment 1520 according to various aspects of this disclosure.

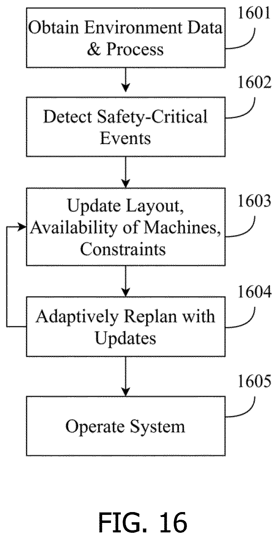

FIG. 16 shows an exemplary flow diagram with respect to adaptive planning, which the controller 504 may perform. The controller may obtain 1601 environment data from the memory and process the environment data by identifying safety-critical events based on rules stored in the memory, and/or based on an AI/ML configured to identify safety-critical events.

Based on the processing, the controller may detect 1602 safety-critical events and update the layout by removing and/or adding sections to an available environment (e.g. a floorplan) for the device to determine a new layout. The controller may further add or remove autonomous machines according to the safety-critical events, and adjust the constraints of the environment to determine a new layout. Furthermore, the controller may adaptively re-plan 1604 the system by generating more layouts according to the updates and constraints and determining a new layout. The controller may control the autonomous machine clusters accordingly to deploy the autonomous machines with updated operation policies for the new determined layout. The controller may further operate 1605 system with an intention to provide maximum efficiency even under safety-critical scenarios.

The following table illustrates, by way of example, exemplary scenarios, security criteria, risks, mitigation possibilities, and potential re-plan decisions in a system according to various aspects of this disclosure.

| Scenario | Criteria | Risk | Mitigation | Re-plan Decision |
|---|---|---|---|---|
| Human / Autonomous machine Distance & Proximity based | Far | No direct physical contact, Low Risk | Continue autonomous machine tasks as planned | - |

(continued)

| Scenario | Criteria | Risk | Mitigation | Re-plan Decision |
|---|---|---|---|---|
| on trajectory prediction | Close & congested settings | High Risk, Potential Harmful physical contact & collisions | Stop autonomous machines / Machines (using a local controller) | Remove & Block out specific locations in human proximity, re-plan factory system |
| Based on human activity inferencing, autonomous machine decides human wants to interact | Both human and autonomous machine are static or dynamic | Medium Risk, Controlled Interaction | Cautiously cut autonomous machine speeds with safety criteria | Modify autonomous machine reward structure, re-plan |
| | Sensors measure critical bio parameters (fast breathing etc.) | High Risk, No interaction possible | Stop autonomous machines (using local controller) | Remove & Block out specific autonomous machine states in close human proximity & retrain RL model |
| Shared Workspace | Structured | Medium /High Risk | | Modify autonomous machine reward structure in RL model & |
| | Unstructured | High Risk | | Remove & Block out specific autonomous machine states in close |
| Autonomous machine Communications | autonomous machine Connection Failure (e.g. signal strength < 20dB) | High Risk | Stop autonomous machines (using local controller) | Remove & Block out specific autonomous machine states with no connectivity & re-plan |
| | Connected | Low Risk | Continue autonomous machine tasks as planned | |
| Perception Quality | Visibility Low based check key-point feature detection accuracy | High | Stop autonomous machines (using local controller) | Remove & Block out specific autonomous machine states affected by human proximity |

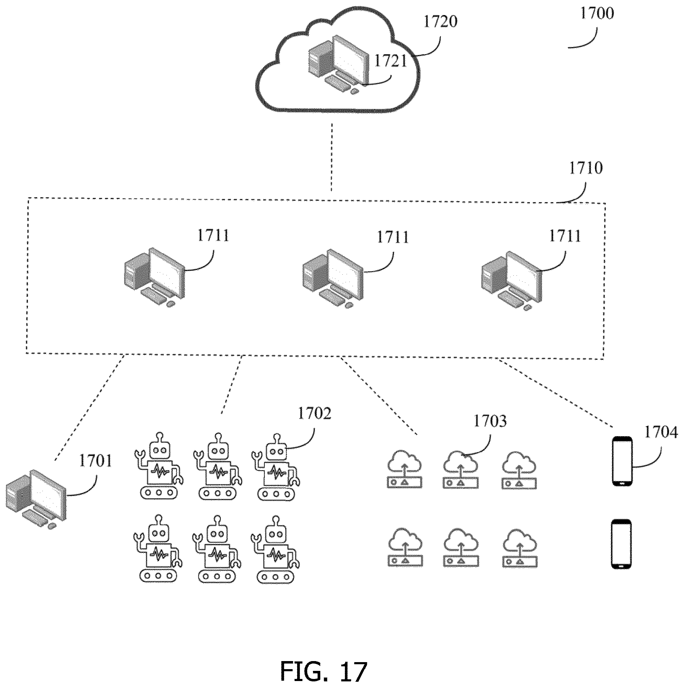

FIG. 17 shows an example of a system according to various aspects of this disclosure. The system 1700 may include a computing device 1701 and a plurality of autonomous machines 1702 configured to operate as autonomous machine clusters. The computing device 1701 may include the device (e.g. the device 400) as provided in this disclosure. The system 1700 may further include a plurality of sensor 1703 that are configured to provide detection and monitoring information with respect to various modalities. The system 1700 may further include other user devices 1704 collectively working with the computing device 1701.

In various examples, the system may include an edge computing system. Accordingly, the system may include an edge network 1710 providing various services to other entities that are communicatively coupled to the edge network 1710 including the computing device 1701, the autonomous machines 1702, the sensors 1703, and the user devices 1704. The edge network 1710 may include a plurality of edge devices 1711 which may be an edge computing device or an edge node. In accordance with various aspects of this disclosure, at least one of the edge devices 1711 may include the device (e.g. the device 400) as provided in this disclosure. In various examples, each of the entities may be communicatively coupled to the cloud 1720 and receive services from one or more cloud computing devices 1721. In accordance with various aspects of this disclosure, at least one of the cloud computing devices 1721 may include the device (e.g. the device 400) as provided in this disclosure.

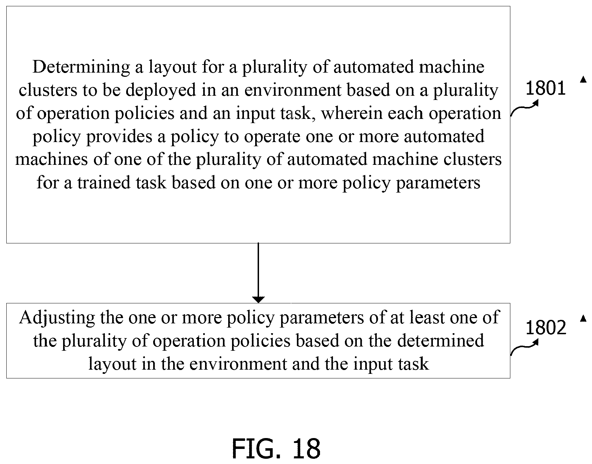

FIG. 18 shows an example of a method. The method may include determining 1801 a layout for a plurality of automated machine clusters to be deployed in an environment based on a plurality of operation policies and an input task, wherein each operation policy provides a policy to operate one or more automated machines of one of the plurality of automated machine clusters for a trained task based on one or more policy parameters, and adjusting 1802 the one or more policy parameters of at least one of the plurality of operation policies based on the determined layout in the environment and the input task.

Throughout the drawings, it should be noted that like reference numbers are used to depict the same or similar elements, features, and structures, unless otherwise noted. It should be noted that certain components may be omitted for the sake of simplicity. It should be noted that nodes (dots) are provided to identify the circuit line intersections in the drawings including electronic circuit diagrams.

As used herein, a signal that is "indicative of" or "indicating" a value or other information may be a digital or analog signal that encodes or otherwise, communicates the value or other information in a manner that can be decoded by and/or cause a responsive action in a component receiving the signal. The signal may be stored or buffered in computer-readable storage medium prior to its receipt by the receiving component and the receiving component may retrieve the signal from the storage medium. Further, a "value" that is "indicative of" some quantity, state, or parameter may be physically embodied as a digital signal, an analog signal, or stored bits that encode or otherwise communicate the value.

As used herein, a signal may be transmitted or conducted through a signal chain in which the signal is processed to change characteristics such as phase, amplitude, frequency, and so on. The signal may be referred to as the same signal even as such characteristics are adapted. In general, so long as a signal continues to encode the same information, the signal may be considered as the same signal. For example, a transmit signal may be considered as referring to the transmit signal in baseband, intermediate, and radio frequencies.

The terms "processor" or "controller" as, for example, used herein may be understood as any kind of technological entity that allows handling of data. The data may be handled according to one or more specific functions executed by the processor or 9. Further, a processor or controller as used herein may be understood as any kind of circuit, e.g., any kind of analog or digital circuit. A processor or a controller may thus be or include an analog circuit, digital circuit, mixed-signal circuit, logic circuit, processor, microprocessor, Central Processing Unit (CPU), Graphics Processing Unit (GPU), Digital Signal Processor (DSP), Field Programmable Gate Array (FPGA), integrated circuit, Application Specific Integrated Circuit (ASIC), etc., or any combination thereof. Any other kind of implementation of the respective functions, which will be described below in further detail, may also be understood as a processor, controller, or logic circuit. It is understood that any two (or more) of the processors, controllers, or logic circuits detailed herein may be realized as a single entity with equivalent functionality or the like, and conversely that any single processor, controller, or logic circuit detailed herein may be realized as two (or more) separate entities with equivalent functionality or the like.

The terms "one or more processors" is intended to refer to a processor or a controller. The one or more processors may include one processor or a plurality of processors. The terms are simply used as an alternative to the "processor" or "controller".

The term "user device" is intended to refer to a device of a user (e.g. occupant) that may be configured to provide information related to the user. The user device may exemplarily include a mobile phone, a smart phone, a wearable device (e.g. smart watch, smart wristband), a computer, etc.

As utilized herein, terms "module", "component," "system," "circuit," "element," "slice," " circuit," and the like are intended to refer to a set of one or more electronic components, a computer-related entity, hardware, software (e.g., in execution), and/or firmware. For example, circuit or a similar term can be a processor, a process running on a processor, a controller, an object, an executable program, a storage device, and/or a computer with a processing device. By way of illustration, an application running on a server and the server can also be circuit. One or more circuits can reside within the same circuit, and circuit can be localized on one computer and/or distributed between two or more computers. A set of elements or a set of other circuits can be described herein, in which the term "set" can be interpreted as "one or more."

The term "data" as used herein may be understood to include information in any suitable analog or digital form, e.g., provided as a file, a portion of a file, a set of files, a signal or stream, a portion of a signal or stream, a set of signals or streams, and the like. Further, the term "data" may also be used to mean a reference to information, e.g., in form of a pointer. The term "data", however, is not limited to the aforementioned examples and may take various forms and represent any information as understood in the art. The term "data item" may include data or a portion of data.

It will be understood that when an element is referred to as being "connected" or "coupled" to another element, it can be physically connected or coupled to the other element such that current and/or electromagnetic radiation (e.g., a signal) can flow along a conductive path formed by the elements. Intervening conductive, inductive, or capacitive elements may be present between the element and the other element when the elements are described as being coupled or connected to one another. Further, when coupled or connected to one another, one element may be capable of inducing a voltage or current flow or propagation of an electro-magnetic wave in the other element without physical contact or intervening components. Further, when a voltage, current, or signal is referred to as being "provided" to an element, the voltage, current, or signal may be conducted to the element by way of a physical connection or by way of capacitive, electro-magnetic, or inductive coupling that does not involve a physical connection.

Unless explicitly specified, the term "instance of time" refers to a time of a particular event or situation according to the context. The instance of time may refer to an instantaneous point in time, or to a period of time which the particular event or situation relates to.

Some aspects may be used in conjunction with one or more types of wireless communication signals and/or systems, for example, Radio Frequency (RF), Infra-Red (IR), Frequency-Division Multiplexing (FDM), Orthogonal FDM (OFDM), Orthogonal Frequency-Division Multiple Access (OFDMA), Spatial Divisional Multiple Access (SDMA), Time-Division Multiplexing (TDM), Time-Division Multiple Access (TDMA), Multi-User MIMO (MU-MIMO), General Packet

**EP 4 202 591 B1**

Radio Service (GPRS), extended GPRS (EGPRS), Code-Division Multiple Access (CDMA), Wideband CDMA (WCDMA), CDMA 2000, single-carrier CDMA, multi-carrier CDMA, Multi-Carrier Modulation (MDM), Discrete Multi-Tone (DMT), Bluetooth (BT), Global Positioning System (GPS), Wi-Fi, Wi-Max, ZigBeeTM, Ultra-Wideband (UWB), Global System for Mobile communication (GSM), 2G, 2.5G, 3G, 3.5G, 4G, Fifth Generation (5G) mobile networks, 3GPP, Long Term Evolution (LTE), LTE advanced, Enhanced Data rates for GSM Evolution (EDGE), or the like. Other aspects may be used in various other devices, systems and/or networks.

While the above descriptions and connected figures may depict electronic device components as separate elements, skilled persons will appreciate the various possibilities to combine or integrate discrete elements into a single element. Such may include combining two or more circuits to form a single circuit, mounting two or more circuits onto a common chip or chassis to form an integrated element, executing discrete software components on a common processor core, etc. Conversely, skilled persons will recognize the possibility to separate a single element into two or more discrete elements, such as splitting a single circuit into two or more separate circuits, separating a chip or chassis into discrete elements originally provided thereon, separating a software component into two or more sections and executing each on a separate processor core, etc.

It is appreciated that implementations of methods detailed herein are demonstrative in nature, and are thus understood as capable of being implemented in a corresponding device. Likewise, it is appreciated that implementations of devices detailed herein are understood as capable of being implemented as a corresponding method. It is thus understood that a device corresponding to a method detailed herein may include one or more components configured to perform each aspect of the related method.

All acronyms defined in the above description additionally hold in all claims included herein.


**Claims**

1.  A device (400) comprising:
    a processor (401) configured to:

    determine (1801) a layout for a plurality of automated machine clusters (301, 302, 303) to be deployed in an environment (300) based on a plurality of operation policies and an input task, wherein each operation policy provides a policy to operate one or more automated machines (100) of one of the plurality of automated machine clusters for a trained task based on one or more policy parameters;
    **characterised in that** the processor (401) is configured to determine configuration parameters for the plurality of automated machine clusters (301, 302, 303) based on the input task;
    adjust (1802) the one or more policy parameters of at least one of the plurality of operation policies based on the determined layout in the environment and the input task;
    wherein the at least one of the plurality of operation policies comprises a reinforcement learning policy and the one or more policy parameters comprises parameters of a state action space of the reinforcement learning policy and the adjustment of the one or more policy parameters comprises an adjustment of the state action space based on the configuration parameters.

2.  The device of claim 1,

    wherein the processor is further configured to receive information indicating the input task (701);
    wherein the processor is further configured to select the plurality of operation policies based on the indicated input task;
    wherein the processor is configured to train one of the plurality of operation policies based on the input task (705); and/or
    wherein the processor is communicatively coupled to a user interface to receive the input task (701).

3.  The device of any one of claims 1 or 2,
    wherein the input task further comprises information indicating at least one of a plurality of tasks, input task parameters, a number of automated machines for each automated machine cluster, an automated machine type for each of the automated machine clusters, or the environment.

4.  The device of any one of claims 1 to 3,

    wherein the processor is configured to determine the layout based on a machine learning model configured to receive an input and provide an output comprising at least one generated layout;

wherein the processor is configured to generate a plurality of layouts based on an input information indicating at least one of dimensions of the environment, features of the plurality of automated machine clusters, constraints between the plurality of automated machine clusters, a target performance metric for the each automated machine cluster, safety requirements of the plurality of automated machine clusters, and an image representing the environment;

preferably wherein the processor is configured to generate the plurality of layouts using a generative neural network configured to provide a plurality of generated layouts based on the input information; wherein the generative neural network comprises a generative adversarial network model.

5. The device of claim 4,

wherein the generated plurality of layouts comprises information indicating at least one of a location, a centroid, or a pose for the each one of the plurality of automated machine clusters;

preferably wherein the processor is configured to estimate the interactions using a graphical neural network configured to provide an output comprising an adjacency matrix indicating interactions between the plurality of automated machine clusters.

6. The device of claim 5,

wherein the processor is configured to estimate a performance index for each one of the plurality of generated layouts based on a performance function comprising parameters with respect to the estimated interactions;

preferably wherein the performance function comprises one or more parameters comprising an indication of at least one of inter-cluster distances between each one of the plurality of automated machine clusters, path lengths for the one or more automated machines configured to transport a material for each one of the plurality of automated machine clusters, a sequence for each one of the plurality of automated machine clusters, a weight of an object, a speed of a conveyor belt transporting the object, robotic manipulation parameters, a period of time defining a duration of a partial task, an order of multiple partial tasks, or deadlines for the partial tasks.

7. The device of any one of claims 5 or 6,

wherein the processor is configured to determine a performance score for each one of the plurality of generated layouts using a machine learning model;

wherein the processor is configured to select one of the plurality of generated layouts as the determined layout.

8. The device of any one of claims 5 to 7,
wherein the processor is configured to select the one of the plurality of generated layouts based on at least one of estimated routes for the one or more automated machines, estimated routes for the one or more automated machines estimated to transport a material, or work sequences of automated machines.

9. The device of any one of claims 1 to 8,
wherein the one or more policy parameters comprise information indicating coordinates for the one or more automated machines of the respective automated machine cluster to perform a task.

10. The device of any one of claims 1 to 9,

wherein the processor is configured to adjust the one or more policy parameters of each operation policy by using a machine learning model configured to receive an input comprising the one or more policy parameters of the respective operation policy and provide an output indicating one or more intermediate policy parameters;

preferably wherein the input of the machine learning model further comprises information indicating at least one of dimensions of the environment, features of the respective automated machine cluster, a target performance metric for the respective automated machine cluster, safety requirements of the respective automated machine cluster, constraints between the respective automated machine cluster and other ones of the plurality of automated machine clusters, an image representing the determined layout, assigned tasks for the respective automated machine cluster, or the adjacency matrix.

11. The device of claim 10,

wherein the processor is further configured to train each operation policy by a reinforcement learning model using the one or more intermediate policy parameters to obtain one or more final policy parameters;
preferably wherein the processor is configured to determine a state based on the determined layout and the one or more intermediate policy parameters to train each operation policy;
wherein the determined state comprises a state information indicating at least one of location of the one or more automated machines of the plurality of automated machine clusters, a beginning and a final positions for each automated machines of the plurality of automated machine clusters, a status of each automated machines for the plurality of automated machine clusters indicating whether the respective automated machine is loaded or unloaded, a status of each automated machine clusters indicating whether the respective automated machine cluster is occupied or available, vector positions of the each automated machines of the plurality of automated machine clusters.

12. The device of any one of claims 1 to 11,
wherein the device is an edge computing device or an edge computing node.

13. The device of any one of claims 11 or 12,

further comprising a controller configured to provide instructions to deploy the plurality of automated machine clusters according to the one or more final policy parameters for each operation policy;
wherein the controller is further configured to control each automated machine cluster according to the one or more final policy parameters for the respective operation policy and the respective operation policy;
wherein the controller is further configured to deploy each automated machine cluster according to the determined layout.

14. The device of any one of claims 1 to 13,

wherein the processor is communicatively coupled to a plurality of sensors to receive sensor data;
wherein the processor is configured to obtain environment data representing the environment based on the received sensor data.
wherein the processor is configured to provide instructions to the one or more automated machines based on the environment data.

15. A non-transitory computer-readable medium comprising one or more instructions which, if executed by a processor, cause the processor to:

determine a layout for a plurality of automated machine clusters to be deployed in an environment based on a plurality of operation policies and an input task, wherein each operation policy provides a policy to operate one or more automated machines of one of the plurality of automated machine clusters for a trained task based on one or more policy parameters;
**characterised in that** the processor is caused to
determine configuration parameters for the plurality of automated machine clusters (301, 302, 303) based on the input task;
adjust the one or more policy parameters of at least one of the plurality of operation policies based on the determined layout in the environment and the input task;
wherein the at least one of the plurality of operation policies comprises a reinforcement learning policy and the one or more policy parameters comprises parameters of a state action space of the reinforcement learning policy, and the adjustment of the one or more policy parameters comprises an adjustment of the state action space based on the configuration parameters.

## Patentansprüche

1. Vorrichtung (400), die Folgendes umfasst:
einen Prozessor (401), der konfiguriert ist zum:

Bestimmen (1801) eines Layouts für mehrere Gruppen (301, 302, 303) automatisierter Maschinen, die in einer Umgebung (300) eingesetzt werden sollen, auf der Grundlage von mehreren Betriebsstrategien und einer eingegebenen Aufgabe, wobei jede Betriebsstrategie eine Strategie bereitstellt, um eine oder mehrere automatisierte Maschinen (100) aus einer der mehreren Gruppen automatisierter Maschinen für eine trainierte Aufgabe auf der Grundlage eines oder mehrerer Strategieparameter zu betreiben;
**dadurch gekennzeichnet, dass** der Prozessor (401) konfiguriert ist zum Bestimmen von Konfigurationsparametern für die mehreren Gruppen (301, 302, 303) automatisierter Maschinen auf der Grundlage der eingegebenen Aufgabe und
Einstellen (1802) des einen oder der mehreren Strategieparameter mindestens einer der mehreren Betriebsstrategien auf der Grundlage des bestimmten Layouts in der Umgebung und der eingegebenen Aufgabe;
wobei die mindestens eine der mehreren Betriebsstrategien eine Verstärkungslernstrategie umfasst, der eine oder die mehreren Strategieparameter Parameter eines Zustandsaktionsraums der Verstärkungslernstrategie umfassen und die Einstellung des einen oder der mehreren Strategieparameter eine Einstellung des Zustandsaktionsraums auf der Grundlage der Konfigurationsparameter umfasst.

2. Vorrichtung nach Anspruch 1,

wobei der Prozessor ferner konfiguriert ist, Informationen zu empfangen, die die eingegebenen Aufgabe (701) angeben;
der Prozessor ferner konfiguriert ist, die mehreren Betriebsstrategien auf der Grundlage der angegebenen eingegebenen Aufgabe zu wählen;
der Prozessor konfiguriert ist, eine der mehreren Betriebsstrategien auf der Grundlage der eingegebenen Aufgabe (705) zu trainieren; und/oder
der Prozessor an eine Anwenderschnittstelle kommunikationstechnisch gekoppelt ist, um die eingegebene Aufgabe (701) zu empfangen.

3. Vorrichtung nach einem der Ansprüche 1 oder 2,
wobei die eingegebene Aufgabe ferner Informationen umfasst, die mindestens eines mehrerer Aufgaben, eingegebener Aufgabenparameter, einer Anzahl automatisierter Maschinen für jede Gruppe automatisierter Maschinen, eines Typs einer automatisierten Maschine für jede der Gruppen automatisierter Maschinen oder der Umgebung angeben.

4. Vorrichtung nach einem der Ansprüche 1 bis 3,

wobei der Prozessor konfiguriert ist, das Layout auf der Grundlage eines Modells für maschinelles Lernen zu bestimmen, das konfiguriert ist, eine Eingabe zu empfangen und eine Ausgabe bereitzustellen, die mindestens ein erzeugtes Layout umfasst; und
der Prozessor konfiguriert ist, mehrere Layouts auf der Grundlage eingegebener Informationen zu erzeugen, die mindestens eines von Abmessungen der Umgebung, Merkmalen der mehreren Gruppen automatisierter Maschinen, Abhängigkeiten zwischen den mehreren Gruppen automatisierter Maschinen, einer Zielleistungsfähigkeitsmetrik für jede Gruppe automatisierter Maschinen, Sicherheitsanforderungen der mehreren Gruppen automatisierter Maschinen und einem Bild, das die Umgebung repräsentiert, angeben;
wobei der Prozessor vorzugsweise konfiguriert ist, die mehreren Layouts unter Verwendung eines generativen neuronalen Netzes zu erzeugen, das konfiguriert ist, mehrere erzeugte Layouts auf der Grundlage der eingegebenen Informationen bereitzustellen; wobei das generative neuronale Netz ein generatives kontradiktorisches Netzmodell umfasst.

5. Vorrichtung nach Anspruch 4,

wobei die erzeugten mehreren Layouts Informationen umfassen, die mindestens eines von einem Ort, einem Schwerpunkt oder einer Stellung für jede der mehreren Gruppen automatisierter Maschinen angeben; und
der Prozessor vorzugsweise konfiguriert ist, die Interaktionen unter Verwendung eines graphischen neuronalen Netzes zu schätzen, das konfiguriert ist, eine Ausgabe bereitzustellen, die eine Adjazenzmatrix umfasst, die Interaktionen zwischen den mehreren Gruppen automatisierter Maschinen angibt.

6. Vorrichtung nach Anspruch 5,
wobei der Prozessor konfiguriert ist, einen Leistungsfähigkeitsindex für jedes der mehreren erzeugten Layouts auf der Grundlage einer Leistungsfähigkeitsfunktion zu schätzen, die Parameter in Bezug auf die geschätzten Interaktionen umfasst; und die Leistungsfähigkeitsfunktion vorzugsweise einen oder mehrere Parameter umfasst, die eine Angabe mindestens eines von Entfernungen zwischen Gruppen zwischen sämtlichen der mehreren Gruppen automatisierter Maschinen, Pfadlängen für die eine oder die mehreren automatisierten Maschinen, die konfiguriert sind, ein Material für jede der mehreren Gruppen automatisierter Maschinen zu transportieren, einer Abfolge für jede der mehreren Gruppen automatisierter Maschinen, eines Gewichts eines Objekts, einer Geschwindigkeit eines Förderbands, das das Objekt transportiert, Roboterbetätigungsparametern, eines Zeitraums, der eine Dauer einer Teilaufgabe definiert, einer Reihenfolge von mehreren Teilaufgaben oder Fristen für die Teilaufgaben umfassen.

7. Vorrichtung nach einem der Ansprüche 5 oder 6,

wobei der Prozessor konfiguriert ist, eine Leistungsfähigkeitsbewertung für jedes der mehreren erzeugten Layouts unter Verwendung eines Modells für maschinelles Lernen zu bestimmen und der Prozessor konfiguriert ist, eines der mehreren erzeugten Layouts als das bestimmte Layout zu wählen.

8. Vorrichtung nach einem der Ansprüche 5 bis 7, wobei der Prozessor konfiguriert ist, das eine der mehreren erzeugten Layouts auf der Grundlage mindestens eines von geschätzten Routen für die eine oder die mehreren automatisierten Maschinen, geschätzten Routen für die eine oder die mehreren automatisierten Maschinen, die geschätzt werden, ein Material zu transportieren, oder Arbeitsabfolgen von automatisierten Maschinen zu wählen.

9. Vorrichtung nach einem der Ansprüche 1 bis 8, wobei der eine oder die mehreren Strategieparameter Informationen umfassen, die Koordinaten für die eine oder die mehreren automatisierten Maschinen der jeweiligen Gruppe automatisierter Maschinen zum Durchführen einer Aufgabe angeben.

10. Vorrichtung nach einem der Ansprüche 1 bis 9, wobei der Prozessor konfiguriert ist, den einen oder die mehreren Strategieparameter jeder Betriebsstrategie unter Verwendung eines Modells für maschinelles Lernen einzustellen, das konfiguriert ist, eine Eingabe zu empfangen, die den einen oder die mehreren Strategieparameter der jeweiligen Betriebsstrategie umfasst, und eine Ausgabe bereitzustellen, die einen oder mehrere zwischenzeitliche Strategieparameter angibt; und die Eingabe des Modells für maschinelles Lernen ferner vorzugsweise Informationen umfasst, die mindestens eines von Abmessungen der Umgebung, Merkmalen der jeweiligen Gruppe automatisierter Maschinen, einer Zielleistungsfähigkeitsmetrik für die jeweilige Gruppe automatisierter Maschinen, Sicherheitsanforderungen der jeweiligen Gruppe automatisierter Maschinen, Abhängigkeiten zwischen der jeweiligen Gruppe automatisierter Maschinen und weiterer der mehreren Gruppen automatisierter Maschinen, einem Bild, das das bestimmte Layout repräsentiert, zugewiesenen Aufgaben für die jeweilige Gruppe automatisierter Maschinen oder der Adjazenzmatrix angeben.

11. Vorrichtung nach Anspruch 10,

wobei der Prozessor ferner konfiguriert ist, jede Betriebsstrategie durch ein Verstärkungslernmodell unter Verwendung des einen oder der mehreren zwischenzeitlichen Strategieparameter zu trainieren, um einen oder mehrere endgültige Strategieparameter zu erhalten; der Prozessor vorzugsweise konfiguriert ist, einen Zustand auf der Grundlage des bestimmten Layouts und des einen oder der mehreren zwischenzeitlichen Strategieparameter zu bestimmen, um jede Betriebsstrategie zu trainieren; und der bestimmte Zustand Zustandsinformationen umfasst, die mindestens eines von einem Ort der einen oder der mehreren automatisierten Maschinen der mehreren Gruppen automatisierter Maschinen, einer Anfangs- und einer Endposition für jede automatisierte Maschine der mehreren Gruppen automatisierter Maschinen, einem status jeder automatisierten Maschine für die mehreren Gruppen automatisierter Maschinen, der angibt, ob die jeweilige automatisierte Maschine beladen oder unbeladen ist, einem status jeder Gruppe automatisierter Maschinen, der angibt, ob die jeweilige Gruppe automatisierter Maschinen belegt oder verfügbar ist, und Vektorpositionen jeder der automatisierten Maschinen der mehreren Gruppen automatisierter Maschinen angeben.

12. Vorrichtung nach einem der Ansprüche 1 bis 11, wobei die Vorrichtung eine Edge-Computing-Vorrichtung oder ein Edge-Computing-Knoten ist.

13. Vorrichtung nach einem der Ansprüche 11 oder 12,

die ferner eine Steuereinheit umfasst, die konfiguriert ist, Befehle bereitzustellen, um die mehreren Gruppen automatisierter Maschinen gemäß dem einen oder den mehreren endgültigen Strategieparametern für jede Betriebsstrategie einzusetzen;

wobei die Steuereinheit ferner konfiguriert ist, jede Gruppe automatisierter Maschinen gemäß dem einen oder den mehreren endgültigen Strategieparametern für die jeweilige Betriebsstrategie und der jeweiligen Betriebsstrategie zu steuern; und

die Steuereinheit ferner konfiguriert ist, jede Gruppe automatisierter Maschinen gemäß dem bestimmten Layout einzusetzen.

14. Vorrichtung nach einem der Ansprüche 1 bis 13,

wobei der Prozessor an mehrere Sensoren kommunikationstechnisch gekoppelt ist, um Sensordaten zu empfangen;

der Prozessor konfiguriert ist, Umgebungsdaten, die die Umgebung repräsentieren, auf der Grundlage der empfangenen Sensordaten zu erhalten; und

der Prozessor konfiguriert ist, Befehle für die eine oder die mehreren automatisierten Maschinen auf der Grundlage der Umgebungsdaten bereitzustellen.

15. Nicht transitorisches computerlesbares Medium, das einen oder mehrere Befehle enthält, die, wenn sie durch einen Prozessor ausgeführt werden, den Prozessor veranlassen zum:

Bestimmen eines Layouts für mehrere Gruppen automatisierter Maschinen, die in einer Umgebung eingesetzt werden sollen, auf der Grundlage von mehreren Betriebsstrategien und einer eingegebenen Aufgabe, wobei jede Betriebsstrategie eine Strategie bereitstellt, um eine oder mehrere automatisierte Maschinen aus einer der mehreren Gruppen automatisierter Maschinen für eine trainierte Aufgabe auf der Grundlage eines oder mehrerer Strategieparameter zu betreiben;

dadurch gekennzeichnet, dass der Prozessor veranlasst wird zum Bestimmen von Konfigurationsparametern für die mehreren Gruppen (301, 302, 303) automatisierter Maschinen auf der Grundlage der eingegebenen Aufgabe;

Einstellen des einen oder der mehreren Strategieparameter mindestens einer der mehreren Betriebsstrategien auf der Grundlage des bestimmten Layouts in der Umgebung und der eingegebenen Aufgabe;

wobei die mindestens eine der mehreren Betriebsstrategien eine Verstärkungslernstrategie umfasst, der eine oder die mehreren Strategieparameter Parameter eines Zustandsaktionsraums der Verstärkungslernstrategie umfassen und die Einstellung des einen oder der mehreren Strategieparameter eine Einstellung des Zustandsaktionsraums auf der Grundlage der Konfigurationsparameter umfasst.

**Revendications**

1. Dispositif (400), comprenant :
un processeur (401) configuré pour :

déterminer (1801) une implantation pour une pluralité de groupes de machines automatisées (301, 302, 303) à déployer dans un environnement (300) sur la base d'une pluralité de politiques de fonctionnement et d'une tâche d'entrée, chaque politique de fonctionnement fournissant une politique pour le fonctionnement d'une ou plusieurs machines automatisées (100) de l'un de la pluralité de groupes de machines automatisées pour une tâche entraînée sur la base d'un ou plusieurs paramètres de politique ;

caractérisé en ce que le processeur (401) est configuré pour déterminer des paramètres de configuration pour la pluralité de groupes de machines automatisées (301, 302, 303) sur la base de la tâche d'entrée ;

ajuster (1802) le ou les paramètres de politique d'au moins l'une de la pluralité de politiques de fonctionnement sur la base de l'implantation déterminée dans l'environnement et de la tâche d'entrée ;

l'au moins une de la pluralité de politiques de fonctionnement comprenant une politique d'apprentissage par renforcement et le ou les paramètres de politique comprenant des paramètres d'un espace d'action d'état de la politique d'apprentissage par renforcement et l'ajustement du ou des paramètres de politique comprenant un ajustement de l'espace d'action d'état sur la base des paramètres de configuration.

2. Dispositif selon la revendication 1,

dans lequel le processeur est en outre configuré pour recevoir des informations indiquant la tâche d'entrée (701) ;

dans lequel le processeur est en outre configuré pour sélectionner la pluralité de politiques de fonctionnement sur la base de la tâche d'entrée indiquée ;

dans lequel le processeur est configuré pour entraîner l'une de la pluralité de politiques de fonctionnement sur la base de la tâche d'entrée (705) ; et/ou

dans lequel le processeur est couplé en communication avec une interface utilisateur pour recevoir la tâche d'entrée (701).

**3.** Dispositif selon l'une quelconque des revendications 1 ou 2,
dans lequel la tâche d'entrée comprend en outre des informations indiquant au moins l'un des éléments suivants : une pluralité de tâches, des paramètres de tâches d'entrée, un nombre de machines automatisées pour chaque groupe de machines automatisées, un type de machine automatisée pour chacun des groupes de machines automatisées, ou l'environnement.

**4.** Dispositif selon l'une quelconque des revendications 1 à 3,

dans lequel le processeur est configuré pour déterminer l'implantation sur la base d'un modèle d'apprentissage automatique configuré pour recevoir une entrée et fournir une sortie comprenant au moins une implantation générée ; dans lequel le processeur est configuré pour générer une pluralité d'implantations sur la base d'une information d'entrée indiquant au moins l'un des éléments suivants :
les dimensions de l'environnement, les caractéristiques de la pluralité de groupes de machines automatisées, les contraintes entre la pluralité de groupes de machines automatisées, une métrique de performances cibles pour chaque groupe de machines automatisées, des exigences de sécurité de la pluralité de groupes de machines automatisées, et une image représentant l'environnement ;
le processeur étant de préférence configuré pour générer la pluralité d'implantations en utilisant un réseau neuronal génératif configuré pour fournir une pluralité d'implantations générées sur la base des informations d'entrée ; le réseau neuronal génératif comprenant un modèle de réseau antagoniste génératif.

**5.** Dispositif selon la revendication 4,

dans lequel la pluralité d'implantations générée comprend des informations indiquant au moins l'un des éléments suivants : une localisation, un centroïde ou une pose pour chaque groupe de la pluralité de groupes de machines automatisées ;
le processeur étant de préférence configuré pour estimer les interactions en utilisant un réseau neuronal graphique configuré pour fournir une sortie comprenant une matrice d'adjacence indiquant les interactions entre la pluralité de groupes de machines automatisées.

**6.** Dispositif selon la revendication 5,

dans lequel le processeur est configuré pour estimer un indice de performances pour chaque implantation de la pluralité d'implantations générées sur la base d'une fonction de performances comprenant des paramètres par rapport aux interactions estimées ;
la fonction de performances comprenant de préférence un ou plusieurs paramètres comprenant une indication d'au moins l'un des éléments suivants : les distances intergroupe entre chaque groupe de la pluralité de groupes de machines automatisées, les longueurs de chemin pour la ou les machines automatisées configurées pour transporter un matériel pour chaque groupe de la pluralité de groupes de machines automatisées, une séquence pour chaque groupe de la pluralité de groupes de machines automatisées, un poids d'un objet, une vitesse d'une courroie de convoyeur transportant l'objet, des paramètres de manipulation robotiques, une période de temps définissant une durée d'une tâche partielle, un ordre de multiples tâches partielles, ou des heures limites pour les tâches partielles.

**7.** Dispositif selon l'une quelconque des revendications 5 ou 6,

dans lequel le processeur est configuré pour déterminer un score de performances pour chaque implantation de la pluralité d'implantations générées en utilisant un modèle d'apprentissage automatique ;
le processeur étant configuré pour sélectionner l'une de la pluralité d'implantations générées en tant qu'implantation déterminée.

**8.** Dispositif selon l'une quelconque des revendications 5 à 7,
dans lequel le processeur est configuré pour sélectionner ladite implantation de la pluralité d'implantations générées sur la base d'au moins l'un des éléments suivants : des routes estimées pour la ou les machines automatisées, des routes estimées pour la ou les machines automatisées estimées pour transporter un matériel, ou des séquences de travail de machines automatisées.

**9.** Dispositif selon l'une quelconque des revendications 1 à 8,
dans lequel le ou les paramètres de politique comprennent des informations indiquant des coordonnées pour la ou les machines automatisées du groupe de machines automatisées respectif pour exécuter une tâche.

**10.** Dispositif selon l'une quelconque des revendications 1 à 9,
dans lequel le processeur est configuré pour ajuster le ou les paramètres de politique de chaque politique de fonctionnement en utilisant un modèle d'apprentissage automatique configuré pour recevoir une entrée comprenant le ou les paramètres de politique de la politique de fonctionnement respective et fournir une sortie indiquant un ou plusieurs paramètres de politique intermédiaires ; l'entrée du modèle d'apprentissage automatique comprenant de préférence en outre des informations indiquant au moins l'un des éléments suivants : des dimensions de l'environnement, des caractéristiques du groupe de machines automatisées respectif, une métrique de performances cibles pour le groupe de machines automatisées respectif, des exigences de sécurité du groupe de machines automatisées respectif, des contraintes entre le groupe de machines automatisées respectif et d'autres groupes de la pluralité de groupes de machines automatisées, une image représentant l'implantation déterminée, des tâches attribuées pour le groupe de machines automatisées respectif, ou la matrice d'adjacence.

**11.** Dispositif selon la revendication 10,

dans lequel le processeur est en outre configuré pour entraîner chaque politique de fonctionnement par un modèle d'apprentissage par renforcement en utilisant le ou les paramètres de politique intermédiaire pour obtenir un ou plusieurs paramètres de politique finaux ;
le processeur étant de préférence configuré pour déterminer un état sur la base de l'implantation déterminée et du ou des paramètres de politique intermédiaires pour entraîner chaque politique de fonctionnement ;
l'état déterminé comprenant des informations d'état indiquant au moins l'un des éléments suivants : localisation de la ou des machines automatisées de la pluralité de groupes de machines automatisées, une position de début et une position de fin pour chaque machine automatisée de la pluralité de groupes de machines automatisées, un statut de chaque machine automatisée pour la pluralité de groupes de machines automatisées indiquant si la machine automatisée respective est chargée ou non chargée, un statut de chaque groupe de machines automatisées indiquant si le groupe de machines automatisées respectif est occupé ou disponible, des positions de vecteur de chaque machine automatisée de la pluralité de groupes de machines automatisées.

**12.** Dispositif selon l'une quelconque des revendications 1 à 11,
lequel dispositif est un dispositif informatique périphérique ou un nœud informatique périphérique.

**13.** Dispositif selon l'une quelconque des revendications 11 ou 12,

comprenant en outre un contrôleur configuré pour fournir des instructions pour déployer la pluralité de groupes de machines automatisées selon le ou les paramètres de politique finaux pour chaque politique de fonctionnement ;
le contrôleur étant en outre configuré pour commander chaque groupe de machines automatisées selon le ou les paramètres de politique finaux pour la politique de fonctionnement respective et la politique de fonctionnement respective ;
le contrôleur étant en outre configuré pour déployer chaque groupe de machines automatisées en fonction de l'implantation déterminée.

**14.** Dispositif selon l'une quelconque des revendications 1 à 13,

dans lequel le processeur est couplé en communication avec une pluralité de capteurs pour recevoir des données de capteurs ;
le processeur étant configuré pour obtenir des données d'environnement représentant l'environnement sur la base des données de capteurs reçues ;
le processeur étant configuré pour fournir des instructions à la ou aux machines automatisées sur la base des données d'environnement.

**15.** Support non transitoire lisible par ordinateur comprenant des instructions qui, si elles sont exécutées par un processeur, amènent le processeur à :

déterminer une implantation pour une pluralité de groupes de machines automatisées à déployer dans un environnement sur la base d'une pluralité de politiques de fonctionnement et d'une tâche d'entrée, chaque politique de fonctionnement fournissant une politique pour le fonctionnement d'une ou plusieurs machines automatisées de l'un de la pluralité de groupes de machines automatisées pour une tâche entraînée sur la base d'un ou plusieurs paramètres de politique ;

**caractérisé en ce que** le processeur est amené à déterminer des paramètres de configuration pour la pluralité de groupes de machines automatisées (301, 302, 303) sur la base de la tâche d'entrée ;

ajuster le ou les paramètres de politique d'au moins l'une de la pluralité de politiques de fonctionnement sur la base de l'implantation déterminée dans l'environnement et de la tâche d'entrée ;

l'au moins une de la pluralité de politiques de fonctionnement comprenant une politique d'apprentissage par renforcement et le ou les paramètres de politique comprenant des paramètres d'un espace d'action d'état de la politique d'apprentissage par renforcement, et l'ajustement du ou des paramètres de politique comprenant un ajustement de l'espace d'action d'état sur la base des paramètres de configuration.

FIG. 1

FIG. 2

FIG. 3

FIG. 4

FIG. 5

```
┌─────────────────────┐
│  ┌───────────────┐  │
│  │   Execution   │  │
│  │     601       │  │
│  ├───────────────┤  │
│  │   Training    │  │
│  │     602       │  │
│  └───────────────┘  │
└─────────────────────┘
```

# FIG. 6

```
┌─────────────────────────────────────┐
│       Receive an input task 701      │
└─────────────────────────────────────┘
                  │
                  ▼
┌─────────────────────────────────────┐
│        Find operation policies       │
│      based on the input task 702     │
└─────────────────────────────────────┘
                  │
                  ▼
┌─────────────────────────────────────┐
│       Adjust the operation policies  │
│      based on the input task 703     │
└─────────────────────────────────────┘
                  │
                  ▼
┌─────────────────────────────────────┐
│  Determine the closest operation policy as │
│           prior policy 704           │
└─────────────────────────────────────┘
                  │
                  ▼
┌─────────────────────────────────────┐
│         Train the prior policy       │
│      based on the input task 705     │
└─────────────────────────────────────┘
```

# FIG. 7

801

Discriminator

810

812

820

Cluster 3
Centroid [X₃,Y₃,Z₃]
Pose [α₃,β₃,γ₃]

Cluster 2
Centroid [X₂,Y₂,Z₂]
Pose [α₂,β₂,γ₂]

Cluster 1
Centroid [X₁,Y₁,Z₁]
Pose [α₁,β₁,γ₁]

802

**Input Data**
Dimensions
AMR Features
Inter-Cluster Constraints
Target Performance
Safety Requirements

811

Generator

## FIG. 8

902

903

901

Cluster 3
Centroid [X₃,Y₃,Z₃]
Pose [α₃,β₃,γ₃]

Cluster 2
Centroid [X₂,Y₂,Z₂]
Pose [α₂,β₂,γ₂]

Cluster 1
Centroid [X₁,Y₁,Z₁]
Pose [α₁,β₁,γ₁]

AI/ML

## FIG. 9

**FIG. 10**

**FIG. 11**

1201

Input Data
Dimensions
RL Policy
AMR Features
Inter-Cluster Constraints
Target Performance
Safety Requirements
Determined Layout

1202

AI/ML

1203

Intermediate Policy
Parameters

## FIG.12

1301

J1  J2  J3  J4  J5

Cluster 1    C1  C2  C3  C4  C5

1302

Cluster 2    A1  A2  A3

1303

Cluster 3    S1  S2  S3  S4  S5

## FIG. 13

FIG. 14

FIG. 15

FIG. 16

FIG. 17

Determining a layout for a plurality of automated machine clusters to be deployed in an environment based on a plurality of operation policies and an input task, wherein each operation policy provides a policy to operate one or more automated machines of one of the plurality of automated machine clusters for a trained task based on one or more policy parameters

1801

Adjusting the one or more policy parameters of at least one of the plurality of operation policies based on the determined layout in the environment and the input task

1802

FIG. 18

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2020138485 A1
- US 2021200239 A1
- CN 112015174 A